# EUROPEAN PATENT APPLICATION

(11) **EP 4 436 331 A1**
(43) Date of publication of application: **25.09.2024**
(21) Application number: 23211779.6
(22) Date of filing: 23.11.2023
(51) Int. Cl.: H10B 41/27, H10B 41/50, H10B 43/27, H10B 43/50

(54) **SEMICONDUCTOR MEMORY DEVICE**

(30) Priority: 24.03.2023 KR 20230038951; 21.04.2023 KR 20230052984
(71) Applicant: Samsung Electronics Co., Ltd., Suwon-si, Gyeonggi-do 16677 (KR)
(72) Inventor: KIM, Kanglib, 16677 Suwon-si (KR); LEE, Seahoon, 16677 Suwon-si (KR); LIM, Junhee, 16677 Suwon-si (KR)
(74) Representative: Marks & Clerk LLP

(57) **Abstract**

A semiconductor memory device includes a substrate, a plurality of gate stack structures on the substrate that include a plurality of gate lines stacked and a plurality of insulating films between the plurality of gate lines, a plurality of first separation insulating films that are alternately stacked with the plurality of gate lines, where the plurality of gate stack structures and the plurality of first separation insulating films define a contact hole, a contact electrode that is in the contact hole and contacts the plurality of gate stack structures, and one or more second separation insulating film that is on an uppermost gate line of one or more of the plurality of gate stack structures and separates the contact electrode from the uppermost gate line.

## Description

### TECHNICAL FIELD

The present disclosure relates to a semiconductor memory device, and more particularly, to a vertical non-volatile semiconductor memory device.

### BACKGROUND

To improve the degree of integration of a semiconductor memory device, cell transistors may be vertically stacked. In the case of a NAND flash memory device, since one memory cell comprises one transistor, the degree of integration may be improved by vertically stacking the memory cells. It may be desirable to form contact electrodes in a connection region electrically connected to a memory cell region where memory cells are formed.

### SUMMARY

The present disclosure provides a semiconductor memory device having a smaller size.

According to an aspect of the present disclosure, a semiconductor memory device comprises a substrate comprising a main surface that is parallel to a horizontal direction; a plurality of gate stack structures on the substrate and comprising a plurality of gate lines and a plurality of insulating films, where the plurality of gate lines are stacked in a vertical direction that is perpendicular to the horizontal direction, and where the plurality of insulating films are between the plurality of gate lines; a plurality of first separation insulating films that are alternately stacked with the plurality of gate lines, where the plurality of gate stack structures and the plurality of first separation insulating films define a contact hole that extends in the vertical direction, where each of the plurality of gate lines extends in the horizontal direction and through the contact hole; a contact electrode that is in the contact hole and contacts the plurality of gate stack structures; and one or more second separation insulating films on an uppermost gate line of one or more of the plurality of gate stack structures, where the one or more second separation insulating films isolate the contact electrode from the uppermost gate line.

According to another aspect of the present disclosure, a semiconductor memory device comprises a memory cell region comprising a plurality of memory cells on a substrate that comprises a main surface that is parallel to a horizontal direction; and a connection region that is adjacent to the memory cell region and that contacts the memory cell region, where the connection region comprises: a plurality of gate stack structures comprising a plurality of gate lines and a plurality of insulating films, where the plurality of gate lines are stacked in a vertical direction that is perpendicular to the horizontal direction, where the plurality of insulating films are between the plurality of gate lines; a plurality of first separation insulating films that are adjacent to each of the plurality of gate lines, where the plurality of gate stack structures and the plurality of first separation insulating films define a contact hole that extends in the vertical direction, where each of the plurality of gate lines extends in the horizontal direction and through the contact hole; a contact electrode that is in the contact hole and contacts the plurality of gate stack structures; one or more second separation insulating films on an uppermost gate line of each of one or more gate stack structure among the plurality of gate stack structures, where the one or more second separation insulating film separates the contact electrode from the uppermost gate line; and one or more intermediate insulating films between each of the plurality of gate stack structures.

According to another aspect of the present disclosure, a semiconductor memory device comprises a memory cell region comprising a plurality of memory cells on a substrate that comprises main surface that is parallel to a horizontal direction; a through electrode region (TER) that is on a first side of the memory cell region and contacts a peripheral circuit wiring layer on the substrate; and a contact region (CR) that is on one side of the through electrode and contacts the memory cell region, where the through electrode region comprises: one or more insulating gate stack structures that comprise an interlayer insulating film, a plurality of TER gate lines stacked in a vertical direction perpendicular to the horizontal direction and on the interlayer insulating film, and a plurality of TER insulating films between the plurality of gate lines; a through hole that extends in the vertical direction and from the peripheral circuit wiring layer of the substrate, where the through hole exposes the peripheral circuit wiring layer; and a through electrode that extends in the horizontal direction and in the through hole, where the through electrode is on a plurality of first TER separation insulating films that are on one side of each of the TER gate lines and the through hole, and where the contact region comprises: a plurality of gate stack structures including a plurality of CR gate lines and a plurality of CR insulating films alternately stacked in the vertical direction; a contact hole that extends in the vertical direction and in each of the plurality of gate stack structures, where the plurality of gate stack structures extend in the horizontal direction and in the contact hole, and the plurality of first CR separation insulating films are on one side of each first gate line; a contact electrode that is in the contact hole and contacts the plurality of gate stack structures; one or more second CR separation insulating films on an uppermost gate line of each of one or more gate stack structure among the plurality of gate stack structures, where the one or more second CR separation insulation films separate the contact electrode from the uppermost gate line; and one or more intermediate CR insulating films between each of the plurality of gate stack structures.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a block diagram of a semiconductor memory device according to an embodiment of the present disclosure;
FIG. 2 is a schematic perspective view of a semiconductor memory device according to an embodiment of the present disclosure;
FIG. 3 is an equivalent circuit diagram of a memory cell array of a semiconductor memory device according to an embodiment of the present disclosure;
FIG. 4 is a plan view illustrating components of a semiconductor memory device according to an embodiment of the present disclosure;
FIG. 5 is a cross-sectional view showing a cross-sectional configuration along the line I-I' of FIG. 4, a cross-sectional configuration along the line II-II' of FIG. 4, and a cross-sectional configuration along the line III-III' of FIG. 4.
FIGS. 6 and 7 are cross-sectional views showing enlarged portions of regions of FIG. 5;
FIG. 8 is an enlarged cross-sectional view of a portion of a plurality of gate lines and a channel structure of a semiconductor memory device according to an embodiment of the present disclosure;
FIG. 9 is a cross-sectional view showing a cross-sectional configuration along the line I-I' of FIG. 4, a cross-sectional configuration along the line II-II' of FIG. 4, and a cross-sectional configuration along the line III-III' of FIG. 4;
FIGS. 10, 11, 12, 13, 14, 15, and 16 are cross-sectional views illustrating a method of manufacturing a semiconductor memory device according to an embodiment of the present disclosure;
FIG. 17 is a diagram schematically illustrating an electronic system including a semiconductor memory device according to an embodiment of the present disclosure; and
FIG. 18 is a perspective view schematically illustrating an electronic system including a semiconductor memory device according to an embodiment of the present disclosure.

### DETAILED DESCRIPTION OF THE EMBODIMENTS

Hereinafter, embodiments will be described in detail with reference to the accompanying drawings. The same reference numerals are used for the same components in the drawings, and duplicate descriptions thereof are omitted.

To clarify the present disclosure, parts that are not connected with the description will be omitted, and the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof. The term "and/or" includes any and all combinations of one or more of the associated listed items. As used herein, "an element A is at a same level as element B" refers to at least one surface of element A that is coplanar with at least one surface of element B. The term "connected" may be used herein to refer to a physical and/or electrical connection and may refer to a direct or indirect physical and/or electrical connection.

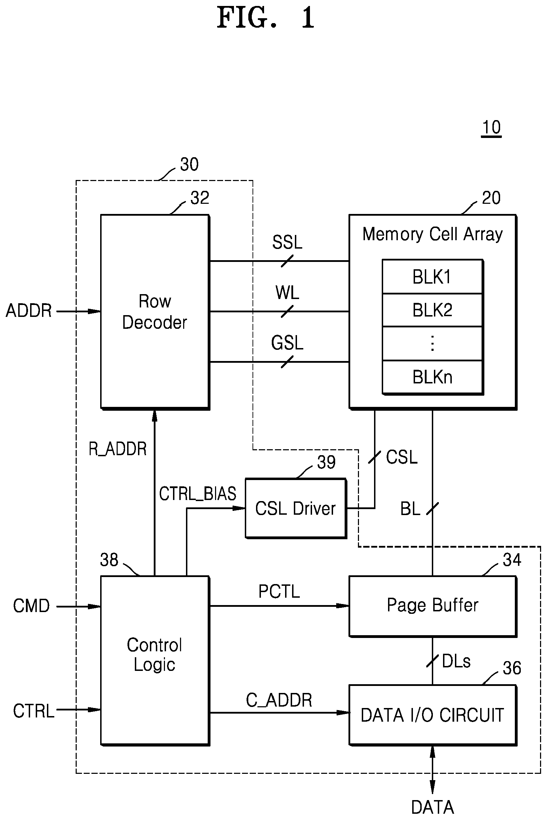

FIG. 1 is a block diagram of a semiconductor memory device according to an embodiment of the present disclosure.

Referring to FIG. 1, a semiconductor memory device 10 may include a memory cell array 20 and a peripheral circuit 30. The memory cell array 20 may include a plurality of memory cell blocks BLK1, BLK2, ..., BLKn, where n is a positive integer. Each of the plurality of memory cell blocks BLK1, BLK2, ..., BLKn may include a plurality of memory cells. The plurality of memory cell blocks BLK1, BLK2, ..., BLKn are connected to the peripheral circuit 30 through a bit line BL, a word line WL, a string select line SSL, and a ground select line GSL.

The peripheral circuit 30 may receive an address ADDR, a command CMD, and a control signal CTRL that is external to the semiconductor memory device 10, and may transmit and receive data DATA with an external device of the semiconductor memory device 10. The peripheral circuit 30 may include a row decoder 32, a page buffer 34, a data input/output (I/O) circuit 36, a control logic 38, and a common source line (CSL) driver 39.

Although not shown in FIG. 1, the peripheral circuit 30 may further include various circuits, such as a voltage generation circuit for generating various voltages for the operation of the semiconductor memory device 10, an error correction circuit for correcting errors in data read from the memory cell array 20, and an input/output interface.

The memory cell array 20 may be connected to the page buffer 34 through a bit line BL. The memory cell array 20 may be connected to the row decoder 32 through a word line WL, a string select line SSL, and a ground select line GSL. In the memory cell array 20, a plurality of memory cells included in each of the plurality of memory cell blocks BLK1, BLK2, ..., BLKn may be flash memory cells. The memory cell array 20 may include a three-dimensional memory cell array. The three-dimensional memory cell array may include a plurality of NAND strings. Each of the plurality of NAND strings may include a plurality of memory cells connected to a plurality of vertically stacked word lines WL.

The peripheral circuit 30 may receive an address ADDR, a command CMD, and a control signal CTRL that is external to the semiconductor memory device 10, and may transmit and receive data DATA with an external device of the semiconductor memory device 10.

The row decoder 32 may select at least one of the plurality of memory cell blocks BLK1, BLK2, ..., BLKn in response to an address ADDR from the outside, and may select a word line WL, a string select line SSL, and a ground select line GSL of the selected memory cell block. The row decoder 32 may transmit a voltage for performing a memory operation to the word line WL of the selected memory cell block.

The page buffer 34 may be connected to the memory cell array 20 through the bit line BL. The page buffer 34 may operate as a write driver during a program operation to apply a voltage according to the data DATA to be stored in the memory cell array 20 to the bit line BL, and may operate as a sense amplifier during a read operation to sense data DATA stored in the memory cell array 20. The page buffer 34 may operate according to a control signal PCTL provided from the control logic 38.

The data I/O circuit 36 may be connected to the page buffer 34 through a plurality of data lines DLs. The data I/O circuit 36 may receive data DATA from a memory controller (not shown) during a program operation, and may provide the program data DATA to the page buffer 34 based on the column address C_ADDR provided from the control logic 38. The data I/O circuit 36 may provide the read data DATA stored in the page buffer 34 to the memory controller based on the column address C_ADDR provided from the control logic 38 during a read operation.

The data I/O circuit 36 may transmit an input address or command to the control logic 38 or the row decoder 32. The peripheral circuit 30 may further include an electrostatic discharge (ESD) circuit and a pull-up/pull-down driver.

The control logic 38 may receive a command CMD and a control signal CTRL from the memory controller. The control logic 38 may provide the row address R_ADDR to the row decoder 32 and provide the column address C_ADDR to the data I/O circuit 36. The control logic 38 may generate various internal control signals used in the semiconductor memory device 10 in response to the control signal CTRL. For example, the control logic 38 may adjust the voltage level provided to the word line WL and the bit line BL when a memory operation such as a program operation or an erase operation is performed.

The common source line driver 39 may be connected to the memory cell array 20 through a common source line CSL. The common source line driver 39 may apply a common source voltage (e.g., a power supply voltage) or a ground voltage to the common source line CSL based on the control signal CTRL_BIAS of the control logic 38. In example embodiments, the CSL driver 39 may be below the memory cell array 20. The CSL driver 39 may vertically overlap with at least a portion of the memory cell array 20.

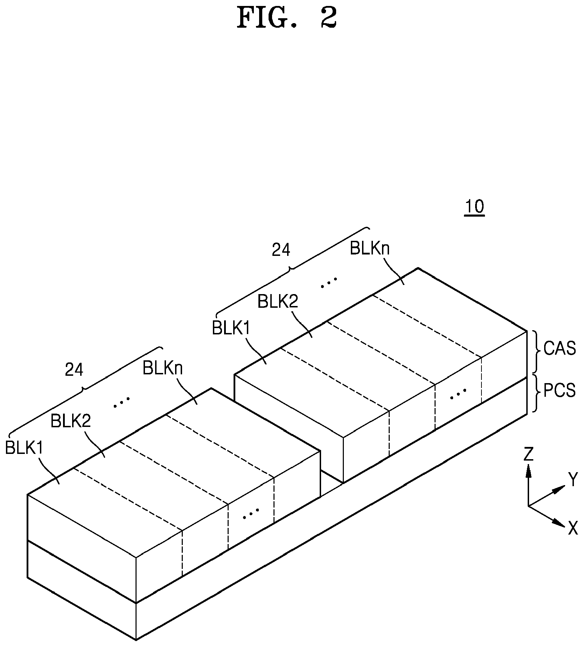

FIG. 2 is a schematic perspective view of a semiconductor memory device according to an embodiment. It will be described with reference to FIG. 1.

Referring to FIG. 2, the semiconductor memory device 10 may include a cell array structure CAS and a peripheral circuit structure PCS overlapping each other in the vertical direction (Z direction).

The cell array structure CAS may include the memory cell array 20 of FIG. 1. The peripheral circuit structure PCS may include the peripheral circuit 30 of FIG. 1. The cell array structure CAS may include a plurality of tiles 24. Each of the plurality of tiles 24 may include a plurality of memory cell blocks BLK1, BLK2, ..., BLKn. Each of the plurality of memory cell blocks BLK1, BLK2, ..., BLKn may include a plurality of memory cells that are three-dimensionally arranged.

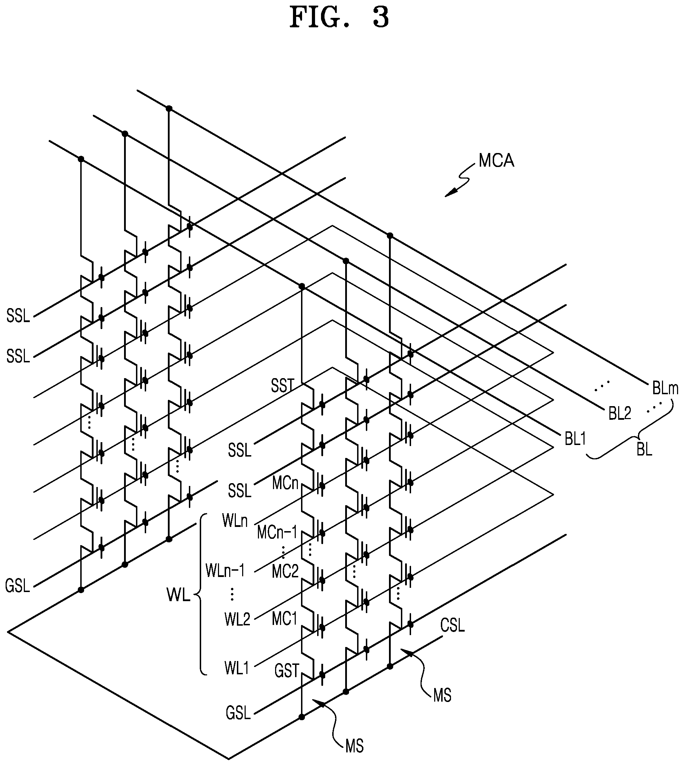

FIG. 3 is an equivalent circuit diagram of a memory cell array of a semiconductor memory device according to an embodiment. FIG. 3 may be an equivalent circuit diagram of a memory cell array (MCA) of the semiconductor memory device 10 described above, for example, a vertical NAND flash memory device. Each of the memory cell blocks BLK1, BLK2, ..., BLKn shown in FIG. 2 may include a memory cell array MCA having the circuit configuration illustrated in FIG. 3. It will be described with reference to FIGS. 1 and 2 together.

Referring to FIG. 3, the memory cell array MCA may include a plurality of memory cell strings MS. Memory cell array MCA may include a plurality of bit lines BL (BL1, BL2, ..., BLm, m is a positive integer), a plurality of word lines WL (WL1, WL2, ..., WLn-1, WLn, where n is a positive integer), at least one string select line SSL, at least one ground select line GSL, and a common source line CSL.

A plurality of memory cell strings MS may be formed between the plurality of bit lines BL and the common source line CSL. FIG. 3 illustrates a case where each of the plurality of memory cell strings MS includes two select lines SSL, but the technical concept of the present disclosure is not limited thereto. For example, each of the plurality of memory cell strings MS may include one string select line SSL.

Each of the plurality of memory cell strings MS may include a string select transistor SST, a ground select transistor GST, and a plurality of memory cell transistors MC1, MC2, ..., MCn-1, MCn (n is a positive integer). The plurality of memory cell transistors MC1, MC2, ..., MCn-1, MCn may be memory cells.

A drain region of the string select transistor SST may be connected to the bit line BL, and a source region of the ground select transistor GST may be connected to the common source line CSL. The common source line CSL may be a region in which the source regions of the plurality of ground selection transistors GST are commonly connected.

The string select transistor SST may be connected to the string select line SSL, and the ground select transistor GST may be connected to the ground select line GSL. The plurality of memory cell transistors MC1, MC2, ..., MCn-1, and MCn may be connected to a plurality of word lines WL, respectively.

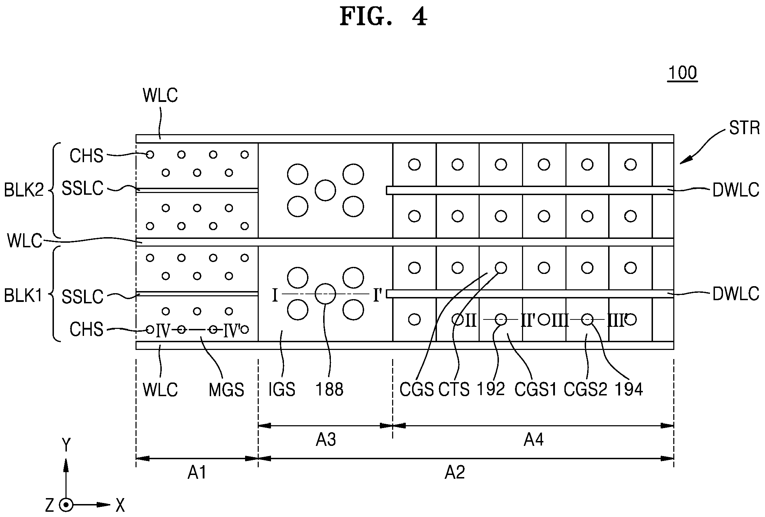

FIG. 4 is a plan view illustrating various components of a semiconductor memory device according to an embodiment. FIG. 4 is a plan view showing configurations of some memory cell blocks BLK1 and BLK2 among the plurality of memory cell blocks BLK1, BLK2, ..., BLKn of FIG. 2. FIG. 4 may be a diagram implementing the semiconductor memory device 10 of FIGS. 1 to 3 described above.

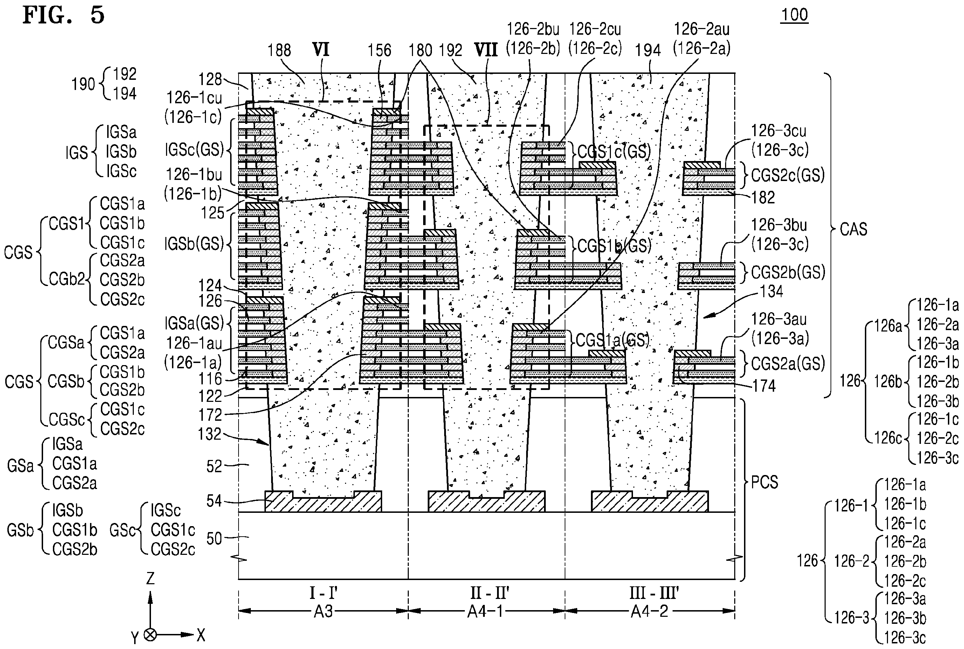

Referring to FIG. 4, the semiconductor memory device 100 may include a memory cell region A1 and a connection region A2 on one side of the memory cell region A1 in the first horizontal direction (X direction). The connection region A2 may include a through electrode region A3 for electrical connection with the peripheral circuit structure PCS (see FIG. 2) and a contact region A4 for electrical connection with a plurality of gate lines 126 (see FIG. 5) of the memory cell region A1 (that is, the ground select line GSL, the plurality of word lines WL, and the string select line SSL of FIG. 2).

In FIG. 4, the through electrode region A3 is adjacent to the right side of the memory cell region A1, but, if necessary, a through electrode region A3 may be adjacent to the right side of the contact region A4.

The cell array structure CAS may be within the memory cell region A1 and the connection region A2. A plurality of word line cut structures WLC extending in the first horizontal direction (X direction) may be within the memory cell region A1 and the connection region A2. The plurality of word line cut structures WLC may be spaced apart from each other in the second horizontal direction (Y direction).

The memory cell blocks BLK1 and BLK2 may be between the plurality of word line cut structures WLC. In some embodiments, a plurality of dummy word line cut structures DWLC extending in a first horizontal direction (X direction) may be within the memory cell blocks BLK1 and BLK2.

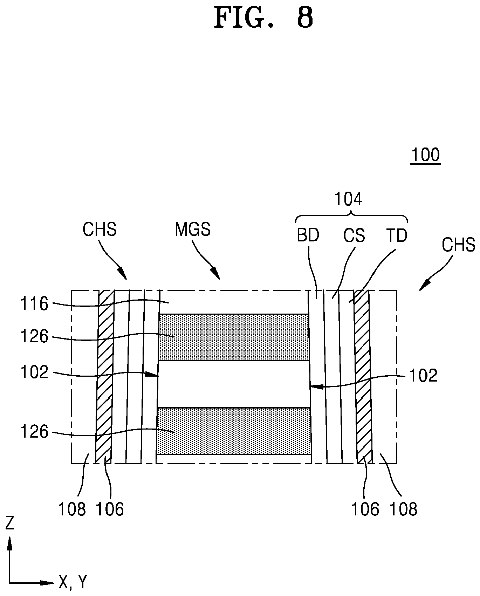

A string select line cut structure SSLC may be within the memory cell region A1. The memory cell region A1 may include a memory gate stack structure MGS and a channel structure CHS formed in the memory gate stack structure MGS. The memory gate stack structure MGS and the channel structure CHS will be described in detail with reference to FIG. 8. The through electrode region A3 may include a through electrode 188 within the insulating gate stack structure IGS. The insulating gate stack structure IGS and the through electrode 188 will be described in detail below.

A plurality of contact gate stack structures CGS having a plurality of step regions STR may be within the contact region A4. In each of a plurality of step regions STR, a contact electrode CTS that contacts a plurality of gate lines 126 (see FIG. 5), that is, a ground select line GSL, a plurality of word lines WL, and a string select line SSL of FIG. 2, may be formed. A plurality of contact electrodes CTS may be formed in the contact gate stack structure CGS.

In FIG. 4, for convenience, the first contact electrode 192 formed on the first contact gate stack structure CGS1 and the second contact electrode 194 formed on the second contact gate stack structure CGS2 are shown. The first contact gate stack structure CGS1, the first contact electrode 192, the second contact gate stack structure CGS2, and the second contact electrode 194 will be described in detail below.

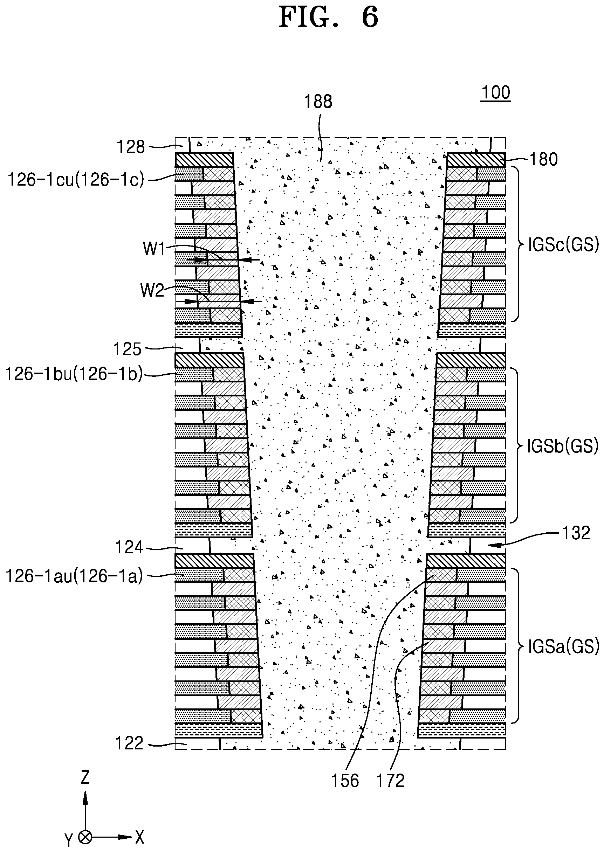

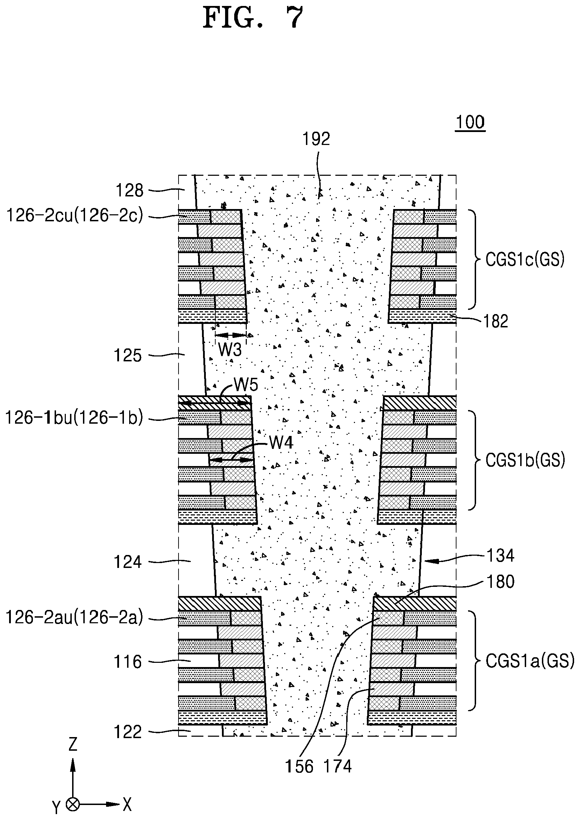

FIG. 5 is a cross-sectional view showing a sectional configuration along the line I-I' of FIG. 4, a sectional configuration along the line II-II' of FIG. 4, and a sectional configuration along the line III-III' of FIG. 4, and FIGS. 6 and 7 are cross-sectional views showing enlarged portions of regions of FIG. 5. FIGS. 5 to 7 show partial cross-sections of the connection region A2. In FIG. 5, the I-I' cross section shows the through electrode region A3 among the connection regions A2, the II-II' cross section shows the first contact region A4-1 among the contact regions A4 constituting the connection region A2, and the III-III' cross section shows the second contact region A4-2 among the contact regions A4. FIG. 6 is an enlarged cross-sectional view of "VI" region of FIG. 5, and FIG. 7 is an enlarged cross-sectional view of "VII" region of FIG. 5. It will be described with reference to FIGS. 1 to 4 together.

Referring to FIGS. 5 to 7, the semiconductor memory device 100 may include a peripheral circuit structure PCS formed on a substrate 50. The peripheral circuit structure PCS may include peripheral transistors, passive elements, capacitors, and the like, but is omitted herein for convenience. The substrate 50 may include a silicon substrate or other material such as silicon germanium, silicon germanium on insulator (SGOI), indium antimonide, lead telluride, indium arsenide, indium phosphide, gallium arsenide, or gallium antimonide, but is not limited thereto.

A main surface of the substrate 50 may be parallel to a horizontal direction (X direction and/or Y direction), and a direction perpendicular to the main surface of the substrate 50 may be a vertical direction (Z direction).

A peripheral circuit insulating layer 52 may be formed on the substrate 50. For example, the peripheral circuit insulating layer 52 may include at least one of silicon oxide, silicon nitride, and silicon oxynitride.

The peripheral circuit wiring layer 54 may be formed on top of the substrate 50 and in the peripheral circuit insulating layer 52. For example, the peripheral circuit wiring layer 54 may be included in the row decoder 32 and the page buffer 34 of FIG. 1. For example, the peripheral circuit wiring layer 54 may include a metallic material, such as tungsten or copper.

The semiconductor memory device 100 may include a cell array structure CAS formed on the peripheral circuit insulating layer 52. As described above, a memory cell region A1 including memory cells may be on the peripheral circuit insulating layer 52, and a connection region A2 may be on one side of the memory cell region A1.

In addition, as previously explained, the connection region A2 may include a through electrode region A3 for electrical connection between the memory cell region A1 and the peripheral circuit structure PCS (that is, the peripheral circuit wiring layer 54, and a contact region A4 for electrical connection with the memory cell region A1). In FIG. 5, for convenience, a first contact region A4-1 and a second contact region A4-2 of the contact region A4 are shown.

The through electrode region A3 may electrically connect the memory cell region A1 to the peripheral circuit structure PCS, that is, the peripheral circuit wiring layer 54. The through electrode region A3 is formed on one side of the first contact region A4-1 to reduce the length of the connection region A2 in the horizontal direction (X direction and/or Y direction). The through electrode region A3 may include an insulating gate stack structure IGS, and the first contact region A4-1 and the second contact region A4-2 may include a first contact gate stack structure CGS1 and a second contact gate stack structure CGS2, respectively.

Each of the insulating gate stack structure IGS and the contact gate stack structure CGS may include a plurality of gate lines 126 stacked in a vertical direction (Z direction) on the interlayer insulating film 122, and a plurality of insulating films 116 formed between the plurality of gate lines 126.

In the through electrode region A3, the plurality of insulating films 116 and the plurality of gate lines 126 may constitute a lower insulating gate stack structure IGSa, an intermediate insulating gate stack structure IGSb, and an upper insulating gate stack structure IGSc stacked in the vertical direction (Z direction).

In the first contact region A4-1, the plurality of insulating films 116 and the plurality of gate lines 126 may constitute a first lower contact gate stack structure CGS1a, a first intermediate contact gate stack structure CGS1b, and a first upper contact gate stack structure CGS1c stacked in the vertical direction (Z direction). In the second contact region A4-2, the plurality of insulating films 116 and the plurality of gate lines 126 may constitute a second lower contact gate stack structure GS2a, a second intermediate contact gate stack structure CGS2b, and a second upper contact gate stack structure CGS2c stacked in the vertical direction (Z direction). The first lower contact gate stack structure CGS1a, the first intermediate gate stack structure GS1b and the first upper contact gate stack structure CGS1c may form the first contact gate stack structure CGS1, and the second lower contact gate stack structure CGS2a, the second intermediate gate stack structure GS2b, and the second upper contact gate stack structure CGS2c may form the second contact gate stack structure CGS2.

The lower insulating gate stack structure IGSa, the first lower contact gate stack structure CGS1a, and the second lower contact gate stack structure CGS2a may be collectively referred to as a lower gate stack structure GSa. The intermediate insulating gate stack structure IGSb, the first intermediate contact gate stack structure CGS1b and the second intermediate contact gate stack structure CGS2b may be collectively referred to as an intermediate gate stack structure GSb. The upper insulating gate stack structure IGSc, the first upper contact gate stack structure CGS1c, and the second upper contact gate stack structure CGS2c may be collectively referred to as an upper gate stack structure GSc.

The lower insulating gate stack structure IGSa, the first lower contact gate stack structure CGS1a, and the second lower contact gate stack structure CGS2a may include a plurality of lower gate lines 126a. The intermediate insulating gate stack structure IGSb, the first intermediate contact gate stack structure CGS1b and the second intermediate contact gate stack structure CGS2b may include a plurality of intermediate gate lines 126b, and the upper insulating gate stack structure IGSc, the first upper contact gate stack structure CGS1c, and the second upper contact gate stack structure CGS2c may include a plurality of upper gate lines 126c.

A lower insulating gate stack structure IGSa, an intermediate insulating gate stack structure IGSb and an upper insulating gate stack structure GSc may include a first lower gate line 126-1a, a first intermediate gate line 126-1b, and a first upper gate line 126-1c, respectively. A first lower contact gate stack structure CGS1a, a first intermediate contact gate stack structure CGS1b and a first upper contact gate stack structure CGS1c may include a second lower gate line 126-2a, a second intermediate gate line 126-2b, and a second upper gate line 126-2c, respectively. A second lower contact gate stack structure CGS2a, a second intermediate gate stack structure GS2b and a second upper contact gate stack structure CGS2c may include a third lower gate line 126-3a, a third intermediate gate line 126-3b, and a third upper gate line 126-3c, respectively.

The first to third lower gate lines 126-1a, 126-2a, and 126-3a may be collectively referred to as lower gate lines 126a, the first to third intermediate gate lines 126-1b, 126-2b, and 126-3b may be collectively referred to as intermediate gate lines 126b, and the first to third upper gate lines 126-1c, 126-2c, and 126-3c may be collectively referred to as a lower gate line 126c.

Each of the lower contact gate stack structure CGSa, the intermediate contact gate stack structure CGSb, and the upper contact gate stack structure CGSc may be a step structure extending in a horizontal direction (X direction and/or Y direction).

For example, the plurality of insulating films 116 may include silicon oxide. The gate line 126 may include a conductive material. For example, the gate line 126 may include tungsten (W), cobalt (Co), nickel (Ni), tantalum (Ta), tungsten nitride, titanium nitride, tantalum nitride, or a combination thereof but the present disclosure is not limited thereto.

As shown in FIGS. 5 and 6, each of the lower insulating gate stack structure IGSa, intermediate insulating gate stack structure IGSb and upper insulating gate stack structure IGSc includes six gate lines 126, each of the first lower contact gate stack structure CGS1a, the first intermediate contact gate stack structure CGS1b and the first upper contact gate stack structure CGS1c includes four gate lines 126, and each of the second lower contact gate stack structure CGS2a, the second intermediate contact gate stack structure CGS2b, and the second upper contact gate stack structure CGS2c includes two gate lines 126, but the present disclosure is not limited thereto. Of course, each of the lower gate stack structure GSa, the intermediate gate stack structure GSb, and the upper gate stack structure GSc may include various numbers of gate lines 126.

An interlayer insulating film 122 may be between the peripheral circuit insulating layer 52 and the lower gate stack structure GSa, and a first intermediate insulating film 124 may be between the lower gate stack structure GSa and the intermediate gate stack structure GSb. In addition, a second intermediate insulating film 125 may be between the intermediate gate stack structure GSb and the upper gate stack structure GSc, and a cover insulating film 128 may be on the upper gate stack structure GSc.

For example, the interlayer insulating film 122, the first intermediate insulating film 124, the second intermediate insulating film 125, and/or the cover insulating film 128 may include silicon oxide. In addition, each of the first intermediate insulating film 124 and the second intermediate insulating film 125 may be thicker than each of the plurality of insulating films 116 and the plurality of gate lines 126.

At least some of the plurality of insulating films 116 of the through electrode region A3 may be at the same vertical level as at least a portion of the plurality of insulating films 116 of the first and second contact regions A4-1 and A4-2. In addition, at least some of the plurality of gate lines 126 of the through electrode region A3 may be at the same vertical level as at least a portion of the plurality of gate lines 126 of the first and second contact regions A4-1 and A4-2. At least a portion of each of the interlayer insulating film 122, the first intermediate insulating film 124, the second intermediate insulating film 125, and/or the cover insulating film 128 of the through electrode region A3 may overlap at least a portion of each of the interlayer insulating film 122, the first intermediate insulating film 124, the second intermediate insulating film 125, and/or the cover insulating film 128 of each of the first and second contact regions A4-1 and A4-2 in a horizontal direction (X direction and/or Y direction).

The through electrode region A3 may include a through hole 132 extending in a vertical direction (Z direction) from the peripheral circuit wiring layer 54 of the substrate 50 within the insulating gate stack structure IGS.

The through hole 132 may expose at least a portion of an upper surface of the peripheral circuit wiring layer 54. The through hole 132 may be formed in the same process as the contact hole 134 of the first and second contact regions A4-1 and A4-2.

The semiconductor memory device 100 may further include a plurality of first separation insulating films 156 to separate (e.g., isolate) the gate line 126 from the through electrode 188 or the gate line 126 from the contact electrode 190. In more detail, the plurality of first separation insulating films 156 may separate the side surface of the gate line 126 from the through electrode 188 or the contact electrode 190.

In the through electrode region A3, the plurality of first separation insulating films 156 may extend inwardly from the inner wall of the through hole 132 toward the center of the through hole 132. A plurality of first separation insulating films 156 may be between the plurality of gate lines 126 and the through electrode 188. Each of the plurality of first separation insulating films 156 may contact the plurality of gate lines 126 and the through hole 132. One side of each of the plurality of first separation insulating films 156 may contact the plurality of gate lines 126, and the other side of each of the plurality of first separation insulating films 156 may contact the through hole 132. For example, the first separation insulating film 156 of the through electrode region A3 may cover the through electrode 188. For example, the plurality of first separation insulating films 156 may include at least one of silicon oxide, silicon nitride, and silicon oxynitride.

In the through electrode region A3, the plurality of first filling insulating films 172 may be between the plurality of first separation insulating films 156 spaced apart in the vertical direction (Z direction) and extending in a horizontal direction (X direction and/or Y direction). The plurality of first filling insulating films 172 may improve the structural stability and electrical stability of the through electrode region A3.

The through electrode region A3 may include a through electrode 188 filled in the through hole 132. The through electrode 188 may include a metal material such as tungsten (W), cobalt (Co), nickel (Ni), or copper (Cu). The through electrode 188 may contact the first lower gate stack structure GS1a, the first intermediate gate stack structure GS1b, and the first upper gate stack structure GS1c within the through hole 132.

In more detail, and in a plan view, each of the plurality of first separation insulating films 156 may be within the through hole 132. In addition, each of the first separation insulating films 156 may overlap a plurality of adjacent first filling insulating films 172 in a vertical direction (Z direction). Also, in a plan view, at least a portion of each of the plurality of first filling insulating films 172 may be within the through hole 132.

In a vertical section, the first separation insulating film 156 may have a first width W1 in a horizontal direction (X direction and/or Y direction), and the first filling insulating film 172 may have a second width W2 in a horizontal direction (X direction and/or Y direction). The first width W1 may be equal to or greater than the second width W2.

The contact hole 134 is formed within each of the first and second contact gate stack structures CGS1 and CGS2 so that one end of each of the plurality of gate lines 126 and the plurality of first separation insulating films 156 extend from the inner wall and in the vertical direction (Z direction). The contact hole 134 may extend from the inside of the contact gate stack structure CGS to the peripheral circuit wiring layer 54 of the substrate 50 in a vertical direction (Z direction). The through hole 134 may expose at least a portion of an upper surface of the peripheral circuit wiring layer 54.

Also, in the contact region A4, a plurality of first separation insulating films 156 may be between the plurality of gate lines 126 and the contact electrode 190. Each of the plurality of first separation insulating films 156 may contact the plurality of gate lines 126 and the contact electrode 190. One side of each of the plurality of first separation insulating films 156 may contact the plurality of gate lines 126, and the other side of each of the plurality of first separation insulating films 156 may contact the contact hole 134. For example, the plurality of first separation insulating films 156 may include at least one of silicon oxide, silicon nitride, and silicon oxynitride.

In the first and second contact regions A4-1 and A4-2, the plurality of second filling insulating films 174 may extend in a horizontal direction (X direction and/or Y direction) between the plurality of first separation insulating films 156 spaced apart in the vertical direction (Z direction) and between the plurality of gate lines 126 spaced apart in the vertical direction (Z direction). The plurality of second filling insulating films 174 may improve the structural stability and electrical stability of the contact gate stack structure CGS.

The contact electrode 190 may be formed within the contact hole 134. The contact electrode 190 may include a metallic material, such as tungsten or copper. The lower surface of the contact electrode 190 may be at a vertical level that is below the lower surface of the contact gate stack structure CGS within the contact hole 134. The contact electrode 190 may contact the plurality of gate stack structures GS.

The contact electrode 190 may be electrically connected to at least some gate stack structures GS among the plurality of contact gate stack structures CGS. The contact electrode 190 may be electrically separated from all other gate stack structures GS except for one gate stack structure GS.

For example, the contact electrode 190 may contact the same number of first separation insulating films 156 in each of the plurality of gate stack structures GS. That is, in one contact region A4, the contact electrode 190 may be aligned in the horizontal direction (X direction and/or Y direction) with the same number of gate lines 126 in each of the plurality of gate stack structures GS. In other words, the number of gate lines 126 of each of the plurality of different gate stack structures GS contacted by the contact electrode 190 may be the same.

In another embodiment, at least two gate stack structures GS among a plurality of different gate stack structures GS contacted by the contact electrode 190 may include different numbers of gate lines 126.

To electrically separate/isolate the through electrode 188 and the plurality of insulating gate stack structures IGS or to electrically separate/isolate the contact electrode 190 and at least a portion of the gate stack structure GS of the plurality of contact gate stack structures CGS, the semiconductor memory device 100 may further include a second separation insulating film 180 and a lower separation insulating film 182. Also, the first separation insulating film 156, the second separation insulating film 180, and the lower separation insulating film 182 may cover the through electrode 188 or the contact electrode 190.

For ease of explanation, among the plurality of gate stack structures GS, a gate stack structure GS contacting and electrically connected to the contact electrode 190 is referred to as a select gate stack structure GS, and among the plurality of gate stack structures GS, a gate stack structure GS that contacts the contact electrode 190 and is electrically separated is referred to as an unselect gate stack structure GS.

The second separation insulating film 180 may electrically separate the insulating gate stack structure IGS of the through electrode region A3 from the through electrode 188. For example, the second separation insulating film 180 may be on the uppermost gate line 126 of each insulating gate stack structure IGS of the through electrode region A3.

The second separation insulating film 180 may selectively and electrically separate the gate stack structure GS of the contact region A4 from the contact electrode 190. For example, the second separation insulating film 180 may be on the uppermost gate line 126 of each of at least one gate stack structure GS of the contact region A4. For example, the second separation insulating film 180 may be on the uppermost gate line 126 of each unselect gate stack structure GS.

A lower surface of the second separation insulating film 180 may contact at least a portion of an upper surface of the first separation insulating film 156 and an upper surface of the uppermost gate line 126. In addition, at least a portion of the upper surface of the second separation insulating film 180 may contact the through electrode 188 and/or the contact electrode 190.

In the through electrode region A3 and the contact region A4, the plurality of lower separation insulating films 182 may directly contact the lower surface of the gate stack structure GS. For example, upper surfaces of the plurality of lower separation insulating films 182 may directly contact a lower surface of the gate stack structure GS. The plurality of lower separation insulating films 182 separate the lowermost gate line 126 of each gate stack structure GS from the through electrode 188 and/or the contact electrode 190 to be electrically separated from each other. At least a portion of upper surfaces of each of the plurality of lower separation insulating films 182 may contact the lowermost gate line 126 of the gate stack structure GS.

Lower surfaces of the plurality of lower separation insulating films 182 may contact the interlayer insulating film 122, the first intermediate insulating film 124, and/or the second intermediate insulating film 125. For example, the lower surfaces of the plurality of lower separation insulating films 182 may contact the upper surface of the interlayer insulating film 122, the upper surface of the first intermediate insulating film 124, and/or the upper surface of the second intermediate insulating film 125.

In addition, FIGS. 5 and 6 show that upper surfaces of the plurality of lower separation insulating films 182 directly contact the gate line 126, but upper surfaces of the plurality of lower separation insulating films 182 may directly contact the upper surface of the insulating film 116. That is, an insulating film 116 may be between the plurality of lower separation insulating films 182 and the lowermost gate line 126.

The contact electrode 190 may directly contact the uppermost gate line 126 of the select gate stack structure. In addition, the contact electrode 190 may directly contact each of the first separation insulating film 156, the second filling insulating film 174, the second separation insulating film 180, and the lower separation insulating film 182 in contact with the select gate stack structure.

For example, the second separation insulating film 180 and the lower separation insulating film 182 may include oxide and/or nitride. For example, the second separation insulating film 180 and the lower separation insulating film 182 may include aluminum oxide (Al₂O₃) and/or silicon oxide (SiO₂). However, the materials of the second separation insulating film 180 and the lower separation insulating film 182 are not limited thereto.

In a vertical section, the first separation insulating film 156 may have a third width W3 in a horizontal direction (X direction and/or Y direction), the second filling insulating film 174 may have a fourth width W4 in a horizontal direction (X direction and/or Y direction), and the second separation insulating film 180 may have a fifth width W5 in a horizontal direction (X direction and/or Y direction). The third width W3 may be less than the fourth width W4. When the third width W3 is less than the fourth width W4, the contact electrode 190 may contact the gate line 126. Also, the fourth width W4 may be equal to or less than the fifth width W5. When the fourth width W4 is equal to or less than the fifth width W5, the contact electrode 190 may contact the gate line 126. For example, the third width W3 may be substantially equal to the first width W1, and the second width W2 may be substantially equal to the fourth width W4.

In a plan view, the first separation insulating film 156 may be within the contact hole 134, and at least a portion of the second separation insulating film 180 may be within the contact hole 134.

For convenience of description, the contact electrode 190 within the first contact region A4-1 may be referred to as the first contact electrode 192, and the contact electrode 190 within the second contact region A4-2 may be referred to as a second contact electrode 194. For example, the first contact electrode 192 may directly contact the uppermost second upper gate line 126-2cu of the first upper contact gate stack structure CGS1c. Accordingly, the first contact electrode 192 may be electrically connected to the uppermost second upper gate line 126-2cu of the first upper contact gate stack structure CGS1c. The first contact electrode 192 may be electrically separated from the plurality of gate lines 126 other than the uppermost second upper gate line 126-2cu of the first upper contact gate stack structure CGS1c by the plurality of first separation insulating films 156, the plurality of second filling insulating films 174, and the plurality of second separation insulating films 180.

In addition, the second contact electrode 194 may directly contact the uppermost third intermediate gate line 126-3bu of the second intermediate contact gate stack structure CGS2b. Accordingly, the second contact electrode 194 may be electrically connected to the uppermost third intermediate gate line 126-3bu of the second intermediate contact gate stack structure CGS2b. The second contact electrode 194 may be electrically separated from the plurality of gate lines 126 other than the uppermost third intermediate gate line 126-3bu of the second intermediate contact gate stack structure CGS2b by the plurality of first separation insulating films 156, the plurality of second filling insulating films 174, and the plurality of second separation insulating films 180.

As shown in FIGS. 5 and 7, a second separation insulating film 180 is on the uppermost second intermediate gate line 126-2bu and the uppermost second lower gate line 126-2au of the first contact region A4-1, and the second separation insulating film 180 is on the uppermost third lower gate line 126-3au and the uppermost third upper gate line 126-3cu of the second contact region A4-2, but the present disclosure is not limited thereto.

Accordingly, the first contact electrode 192 may be electrically connected to the first upper contact gate stack structure CGS1c, and the second contact electrode 194 may be electrically connected to the second intermediate contact gate stack structure CGS2b.

Although not shown in FIG. 5, on the through electrode 188 and the contact electrode 190, the semiconductor memory device 100 may include an upper insulating layer (not shown) covering the upper surface of each of the through electrode 188 and the contact electrode 190. Furthermore, the semiconductor memory device 100 may include an upper connection wiring (not shown) and an upper contact (not shown) electrically connected to the through electrode 188 and the contact electrode 190, respectively.

FIGS. 5 and 6 illustrate an embodiment in which a plurality of gate lines 126 are within the through electrode region A3 by way of example, but the present disclosure is not limited thereto. For example, a replacement process in which a plurality of sacrificial layers (not shown) is replaced with a metal (e.g., tungsten). In this case, the first separation insulating film 156, the second separation insulating film 180, and the first filling insulating film 172 may not be formed in the through electrode region A3. The shape of the through electrode 188 is not limited thereto and may be modified in various ways.

In a typical semiconductor memory device, only a gate line of an uppermost contact gate stack structure contacting a contact electrode is electrically connected, thereby requiring a relatively wide space for arranging a plurality of contact gate stack structures.

On the other hand, in the semiconductor memory device 100 of the present disclosure, the contact electrode 190 may be selectively and electrically connected to at least some gate stack structures GS among a plurality of contact gate stack structures CGS and thus, the semiconductor memory device 100 may efficiently arrange a plurality of gate stack structures GS by overlapping the plurality of gate stack structures GS in a vertical direction (Z direction). Accordingly, a space for arranging the contact gate stack structure CGS may be reduced, and thus the size of the semiconductor memory device 100 may be reduced.

In more detail, the select gate stack structure may contact the lower separation insulating film 182, and the unselected gate stack structure may contact the second separation insulating film 180 and the lower separation insulating film 182.

In FIGS. 5 to 7, one through hole 132 and one contact hole 134 are shown as being in contact with a plurality of gate stack structures GS, respectively, but the present disclosure is not limited thereto. For example, one through hole 132 and one contact hole 134 may contact one gate stack structure GS. In this case, after the one-layer gate stack structure GS is formed, one through hole 132 and one contact hole 134 may be formed. After that, another gate stack structure GS may be formed.

FIG. 8 is an enlarged cross-sectional view of a portion of a plurality of gate lines and a channel structure of a semiconductor memory device according to an embodiment. Specifically, FIG. 8 is a cross-sectional view illustrating an enlarged portion of a region of a cross section along the line IV-IV' of FIG. 4. It will be described with reference to FIGS. 4 to 7 together.

Referring to FIG. 8, the semiconductor memory device 100 may include a memory gate stack structure MGS in a memory cell region A1 and a channel structure CHS formed in the memory gate stack structure MGS.

The memory gate stack structure MGS may include a plurality of insulating films 116 and a plurality of gate lines 126 stacked on the second substrate 110. At least one of the plurality of insulating films 116 may be formed at the same vertical level as at least one of the plurality of insulating films 116 of the through electrode region A3, the first contact region A4-1, and the second contact region A4-2.

The channel structure CHS may be formed in the channel hole 102 formed at one side of the memory gate stack structure MGS. The channel structure CHS may include an information storage structure 104, a channel film 106, and a channel filling insulating film 108. The information storage structure 104 includes a blocking dielectric layer BD, a charge storage layer CS, and a tunneling insulating layer TD sequentially formed in the horizontal direction (X direction and/or Y direction) of the channel film 106 from the plurality of gate lines 126.

The blocking dielectric layer BD may be a continuous layer extending in a stacking direction, that is, a vertical direction (Z-axis direction) within the channel hole 102. The blocking dielectric layer BD may be formed of silicon oxide, silicon nitride, or metal oxide.

The tunneling insulating layer TD, the charge storage layer CS, and the blocking dielectric layer BD may be continuous layers extending in a stacking direction, that is, a vertical direction (Z-axis direction) within the channel hole 102. The charge storage layer CS may be a region in which electrons passing through the tunneling insulating layer TD from the channel film 106 may be stored or trapped during a program operation. Electrons stored in the charge storage layer CS may be moved to the channel film 106 through the tunneling insulating layer TD again during the erase operation.

The charge storage layer CS may include silicon nitride, boron nitride, silicon boron nitride, or polysilicon doped with impurities. The tunneling insulating layer TD may include silicon oxide, hafnium oxide, aluminum oxide, zirconium oxide, tantalum oxide, or the like.

Although not shown, a horizontal insulating pattern (not shown) surrounding the plurality of gate lines 126 may be further included. The horizontal insulating patterns may be positioned to face each other between the plurality of gate lines 126 in a stacking direction, that is, a vertical direction (Z direction).

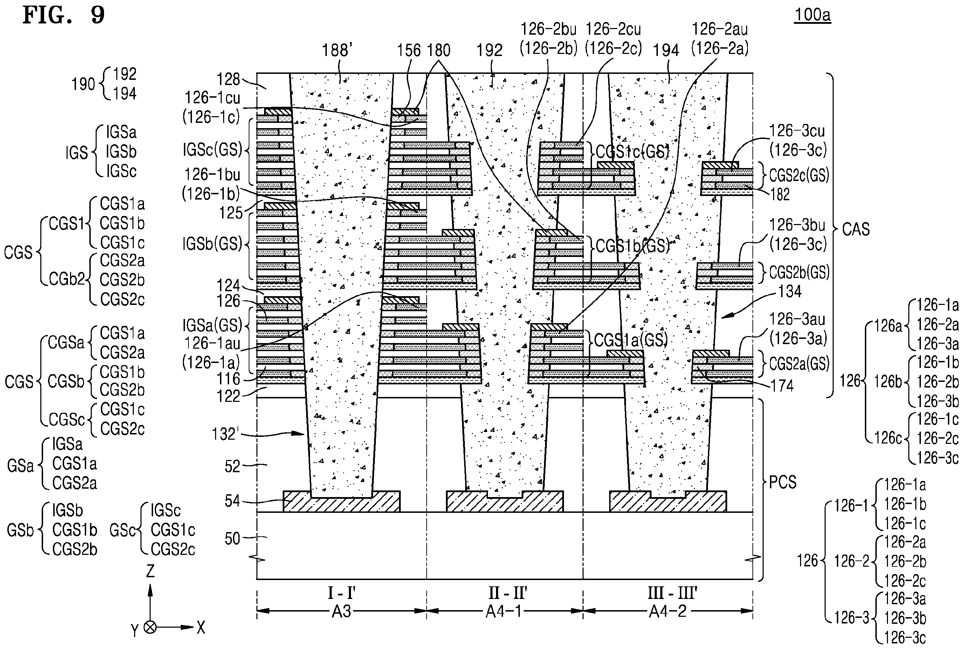

FIG. 9 is a cross-sectional view showing a cross-sectional configuration along the line I-I' of FIG. 4, a cross-sectional configuration along the line II-II' of FIG. 4, and a cross-sectional configuration along the line III-III' of FIG. 4 according to an embodiment. It will be described with reference to FIG. 5.

Referring to FIG. 9, the semiconductor memory device 100a of FIG. 9 may be substantially similar to the semiconductor memory device 100 of FIG. 5, except for the fact that the first filling insulating film 172 and the second separation insulating film 180 are not within the through electrode region A3,.

Also, the plurality of gate lines 126 and/or the first separation insulating film 156 may not extend inwardly along the inner wall of the through hole 132'. That is, in a plan view, each of the plurality of first separation insulating films 156 of the through electrode region A3 may be external to the through hole 132'. That is, in a plan view, each of the plurality of first separation insulating films 156 of the through electrode region A3 may be external to the through electrode 188'.

It is shown in FIG. 9 that the lower separation insulating film 182 is on the lower surface of each of the plurality of insulating gate stack structures IGS of the through electrode region A3. However, in another embodiment, the lower separation insulating film 182 may be omitted in the through electrode region A3.

FIG. 9 illustrates that the second separation insulating film 180 is not within the through electrode region A3 by way of example. However, in another embodiment, a plurality of second separation insulating films 180 may be on the uppermost gate line 126 of the through electrode region A3.

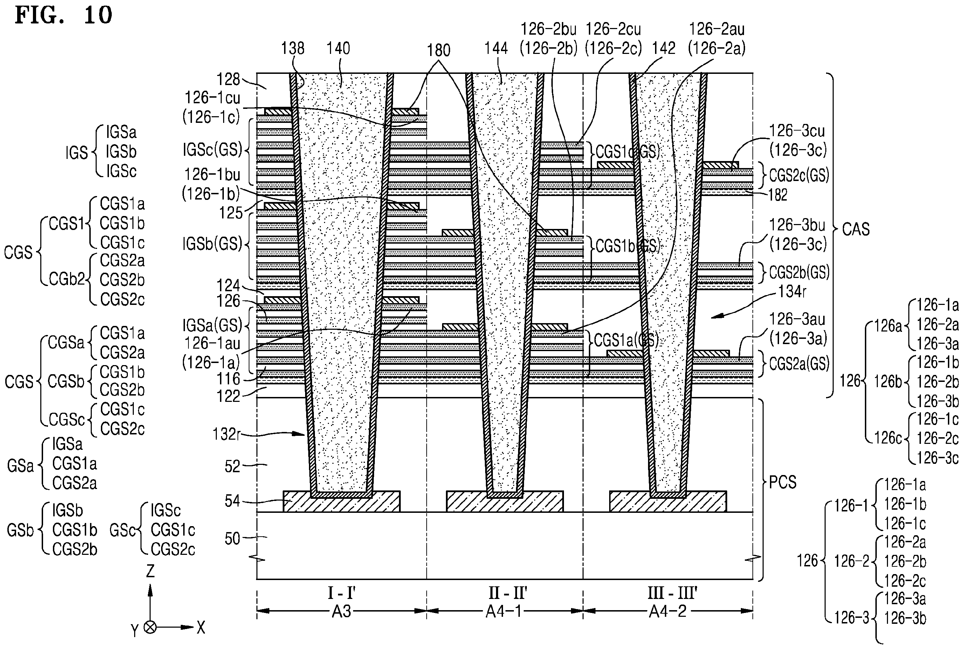

FIGS. 10 to 16 are cross-sectional views illustrating a method of manufacturing a semiconductor memory device, according to an embodiment. Specifically, FIGS. 10 to 16 are cross-sectional views for explaining a method of manufacturing the semiconductor memory device 100 shown in FIGS. 4 to 7. It will be described with reference to FIGS. 4 to 7 together.

Referring to FIG. 10, the semiconductor memory device 100 may include a peripheral circuit structure PCS formed on a substrate 50. A peripheral circuit insulating layer 52 and a peripheral circuit wiring layer 54 may be formed on the substrate 50. The peripheral circuit 30 (see FIG. 1) may be formed on the substrate 50. The substrate 50, the peripheral circuit insulating layer 52, and the peripheral circuit wiring layer 54 may constitute a peripheral circuit structure PCS. The peripheral circuit wiring layer 54 may include a metallic material, such as tungsten or copper.

Subsequently, an interlayer insulating film 122 may be formed on the peripheral circuit insulating layer 52 of the substrate 50. Then, an insulating gate stack structure IGS and a contact gate stack structure CGS are formed on the interlayer insulating film 122. Each of the insulating gate stack structure IGS and the contact gate stack structure CGS may include a plurality of gate lines 126 stacked in a vertical direction (Z direction) on the interlayer insulating film 122, and a plurality of insulating films 116 formed between the plurality of gate lines 126.

The plurality of gate lines 126 may be formed through a replacement process of removing a plurality of sacrificial layers (not shown) and then filling the removed portions with a metal material. At least some of the plurality of gate lines 126 of the first and second contact regions A4-1 and A4-2 may be formed at the same vertical level as at least a part of the plurality of gate lines 126 of the through electrode region A3.

In addition, at least some of the plurality of insulating films 116 of the first and second contact regions A4-1 and A4-2 may be formed at the same vertical level as at least some of the plurality of insulating films 116 of the through electrode region A3.

In addition, a plurality of lower separation insulating films 182 contacting a lower surface of each gate stack structure GS may be formed. The plurality of lower separation insulating films 182 may be formed before the gate stack structure GS is formed.

The plurality of insulating films 116 may include silicon oxide. The plurality of gate lines 126 may include tungsten, nickel, cobalt, tantalum, tungsten nitride, titanium nitride, tantalum nitride, or a combination thereof, but are not limited to these materials.

In addition, a first intermediate insulating film 124 is formed between the lower gate stack structure GSa and the intermediate gate stack structure GSb, and a second intermediate insulating film 125 may be formed between the intermediate gate stack structure GSb and the upper gate stack structure GSc. The first and second intermediate insulating films 124 and 125 may include silicon oxide.

The insulating gate stack structure IGS may include a lower insulating gate stack structure IGSa, an intermediate insulating gate stack structure IGSb, and an upper insulating gate stack structure IGSc sequentially stacked in the vertical direction (Z direction) on the interlayer insulating film 122.

The first and second contact gate stack structures CGS1 and CGS2 are formed in the first and second contact regions A4-1 and A4-2, respectively. The contact gate stack structure CGS may include a lower contact gate stack structure CGSa, an intermediate contact gate stack structure CGSb, and an upper contact gate stack structure CGSc sequentially stacked in the vertical direction (Z direction) on the interlayer insulating film 122.

A second separation insulating film 180 may be formed on the uppermost gate line of each of the plurality of insulating gate stack structures IGS. In addition, a second separation insulating film 180 may be formed on the uppermost gate line of each of the gate stack structures GS of at least some of the plurality of contact gate stack structures CGS. The unselected gate stack structure may contact the second separation insulating film 180, and the select gate stack structure may be spaced apart from the second separation insulating film 180.

For example, the second separation insulating film 180 and the plurality of lower separation insulating films 182 may include oxide and/or nitride. As another example, the second separation insulating film 180 and the plurality of lower separation insulating films 182 may include aluminum oxide (Al2O3) and/or silicon oxide (SiO2). However, materials of the second separation insulating film 180 and the plurality of lower separation insulating films 182 are not limited thereto.

At least a portion of the second separation insulating film 180 may not overlap the through electrode 188 and/or the contact electrode 190 in a vertical direction (Z direction). In a plan view, at least a portion of the second separation insulating film 180 may be external to the through electrode 188 and/or the contact electrode 190. A gate stack structure GS including the through electrode 188 and/or the contact electrode 190 and the second separation insulating film 180 may be electrically separated from each other by a portion of the second separation insulating film 180 that does not overlap the through electrode 188 and/or the contact electrode 190 in the vertical direction (Z direction).

Then, a cover insulating film 128 is formed on the upper gate stack structure GSc of the first and second contact regions A4-1 and A4-2. The cover insulating film 128 may be formed of silicon oxide.

A thickness of the cover insulating film 128 within the second contact region A4-2 may be greater than a thickness of the cover insulating film 128 within the first contact region A4-1. Also, the thickness of the cover insulating film 128 within the through electrode region A3 may be greater than the thickness of the cover insulating film 128 within the first contact region A4-1. The cover insulating film 128 of the through electrode region A3 and the cover insulating film 128 of the first and second contact regions A4-1 and A4-2 may be formed at the same time.

Then, a mask layer (not shown) is formed on the cover insulating film 128. In the through electrode region A3, the mask layer is used as an etching mask and the peripheral circuit insulating layer 52, the interlayer insulating film 122, the first intermediate insulating film 124, the second intermediate insulating film 125, the cover insulating film 128, and the insulating gate stack structure IGS are etched, so that a preliminary through hole 132r exposing the peripheral circuit wiring layer 54 is formed.

Next, the mask layer is used as an etching mask in the first and second contact regions A4-1 and A4-2, and the peripheral circuit insulating layer 52, the interlayer insulating film 122, the first intermediate insulating film 124, the second intermediate insulating film 125, the cover insulating film 128, and the contact gate stack structure CGS are etched, so that a preliminary contact hole 134r exposing the peripheral circuit wiring layer 54 is formed. For example, the preliminary through hole 132r and the preliminary contact hole 134r may be formed simultaneously.

Next, first and second sacrificial spacer layers 138 and 142 are formed in the preliminary through hole 132r and the preliminary contact hole 134r, respectively. For example, the first and second sacrificial spacer layers 138 and 142 may be formed simultaneously.

Subsequently, a first sacrificial filling insulating layer 140 is formed on the first sacrificial spacer layer 138 on the preliminary through hole 132r. The second sacrificial filling insulating layer 144 is filled on the second sacrificial spacer layer 142 on the preliminary contact hole 134r. The first and second sacrificial filling insulating layers 140 and 144 may be formed simultaneously.

FIG. 10 shows that each of one preliminary through hole 132r and one preliminary contact hole 134r is in contact with a plurality of gate stack structures GS, but the present disclosure is not limited thereto. For example, one preliminary through hole 132r or one preliminary contact hole 134r may contact one gate stack structure GS. In this case, after the one-layer gate stack structure GS is formed, the preliminary through hole 132r and the preliminary contact hole 134r may be formed. After that, another gate stack structure GS may be formed.

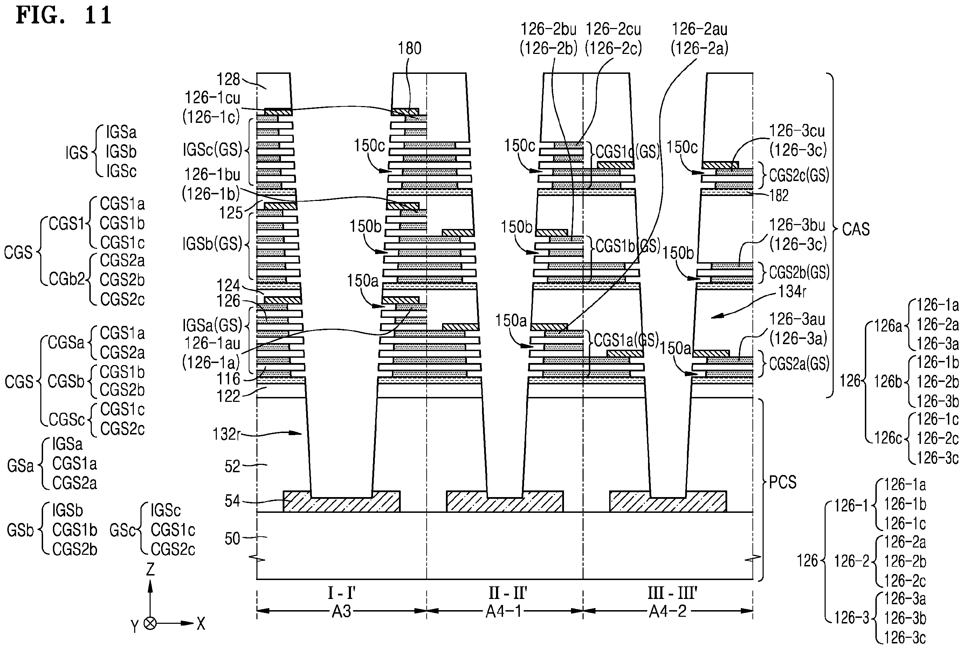

Referring to FIG. 11, the first sacrificial spacer layer 138 (see FIG. 10) and the first sacrificial filling insulating layer 140 (see FIG. 10) of the through electrode region A3 are removed by an etching process. Next, the second sacrificial spacer layer 142 (see FIG. 10) and the second sacrificial filling insulating layer 144 (see FIG. 10) of the first and second contact regions A4-1 and A4-2 are removed by an etching process.

At least a portion of each of the plurality of gate lines 126 contacting preliminary contact holes 134r of the first and second contact regions A4-1 and A4-2 in contact with the preliminary through holes 132r of the through electrode region A3 is etched in a horizontal direction (X direction and/or Y direction) to form first recess holes 150a, 150b, and 150c. The first recess holes 150a, 150b, and 150c of the through electrode region A3 may be formed at the same vertical level as each of the plurality of gate lines 126 of the through electrode region A3. In addition, the first recess holes 150a, 150b, and 150c of each of the first and second contact regions A4-1 and A4-2 may be formed at the same vertical level as each of the plurality of gate lines 126 of the first and second contact regions A4-1 and A4-2.

For example, each of the first sacrificial spacer layer 138 (see FIG. 10), the first sacrificial filling insulating layer 140 (see FIG. 10), the second sacrificial spacer layer 142 (see FIG. 10), and the second sacrificial filling insulating layer 144 (see FIG. 10) may be removed simultaneously.

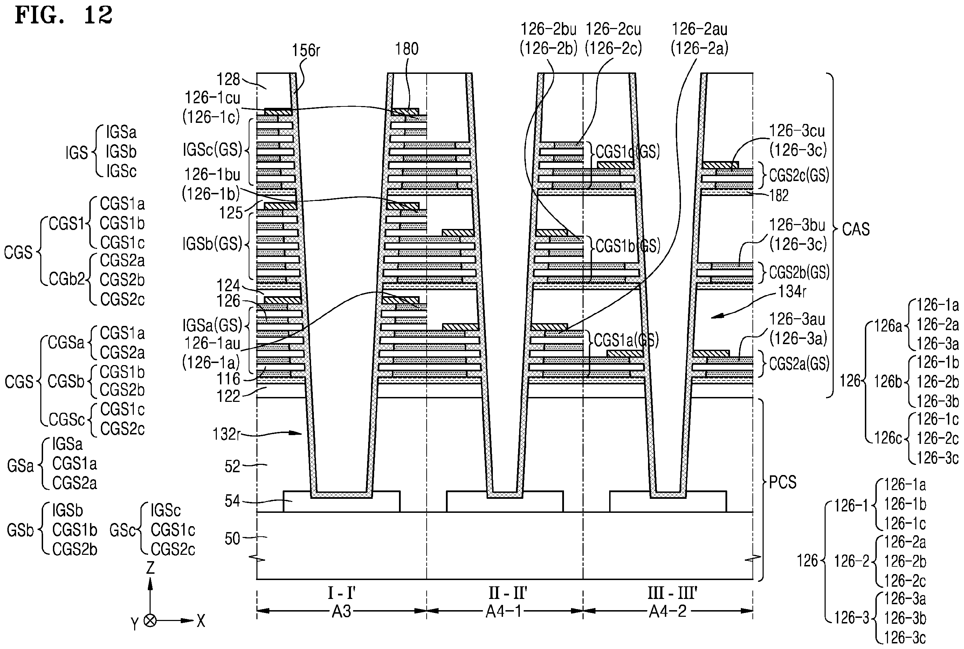

Referring to FIG. 12, a separation insulating material film 156r is formed on the inner wall of the preliminary through hole 132r of the through electrode region A3 and inside the first recess holes 150a, 150b, and 150c. In addition, a separation insulating material film 156r is formed on inner walls of the preliminary contact holes 134r of the first and second contact regions A4-1 and A4-2 and inside the first recess holes 150a, 150b, and 150c. The separation insulating material film 156r may include at least one of silicon oxide, silicon nitride, and silicon oxynitride.

For example, the separation insulating material films 156r of the through electrode region A3, the first contact region A4-1, and the second contact region A4-2 may be formed at the same time.

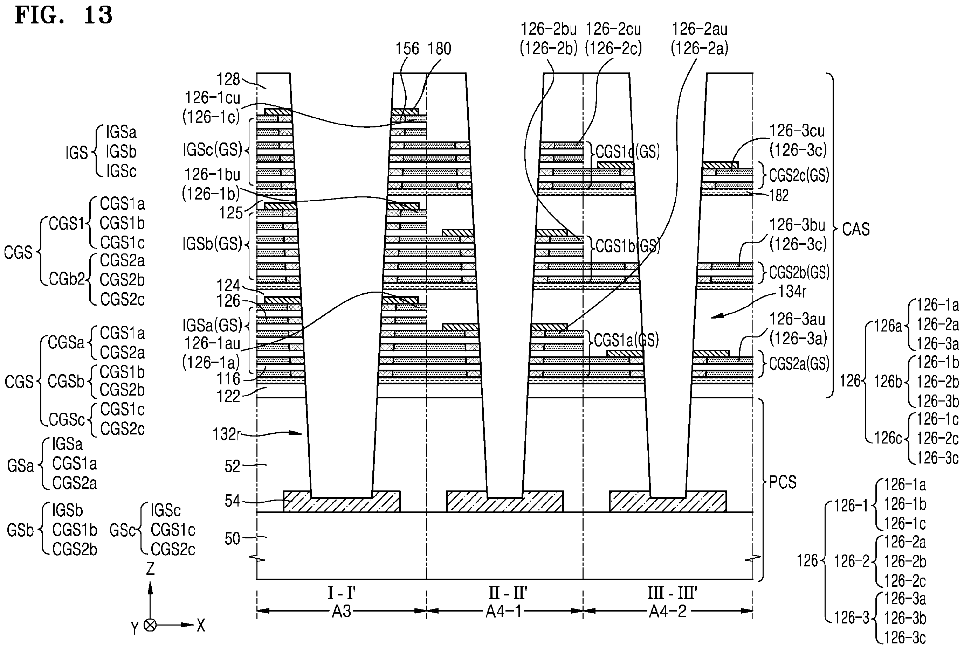

Referring to FIG. 13, the separation insulating material film 156r (see FIG. 12) formed on the inner wall of the preliminary through hole 132r in the through electrode region A3 is etched. In addition, the separation insulating material film 156r (see FIG. 10) formed on the inner wall of the preliminary contact hole 134r is etched in the first and second contact regions A4-1 and A4-2. Accordingly, the first separation insulating film 156 within only the first recess holes 150a, 150b, and 150c of each of the through electrode region A3 and the contact region A4.

For example, the separation insulating material films 156r (see FIG. 12) of the through electrode region A3, the first contact region A4-1, and the second contact region A4-2 may be simultaneously removed.

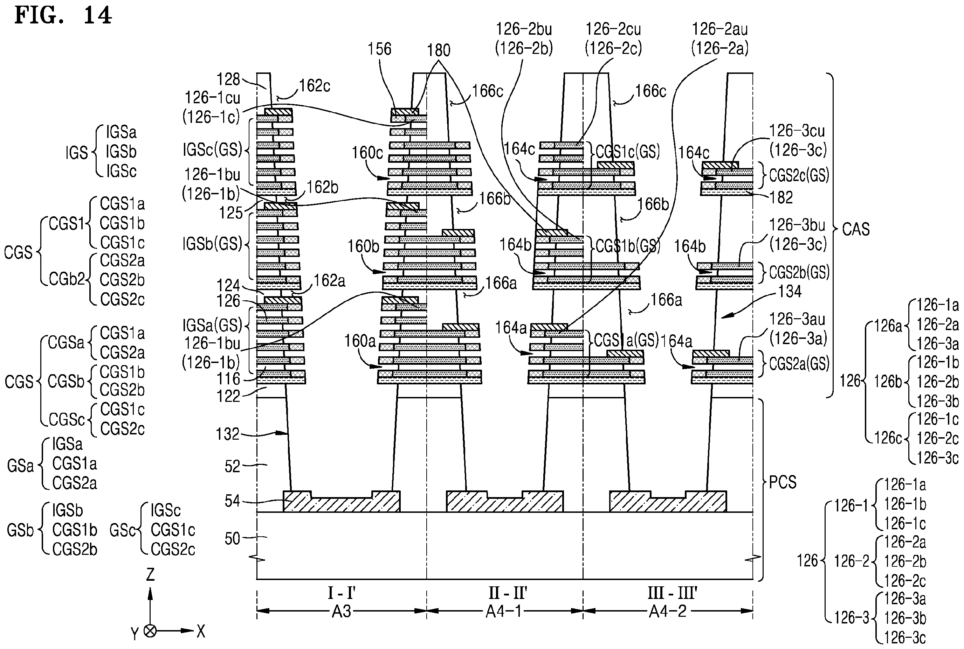

Referring to FIG. 14, the peripheral circuit insulating layer 52, the plurality of insulating films 116, the interlayer insulating film 122, the first intermediate insulating film 124, the second intermediate insulating film 125, and the cover insulating film 128 contacting the preliminary through hole 132r (see FIG. 13) in the through electrode region A3 are etched in a horizontal direction (X direction and/or Y direction), so that a through hole 132 is formed. In a plan view, each of the plurality of first separation insulating films 156 of the electrode region A3 and the contact region A4 may be positioned inside the through hole 132.

As the plurality of insulating films 116 are etched in the horizontal direction (X direction and/or Y direction), the second recess holes 160a, 160b, and 160c may be formed between the plurality of first separation insulating films 156 adjacent to each other of the lower insulating gate stack structure IGSa, the intermediate insulating gate stack structure IGSb and the upper insulating gate stack structure IGSc.

In addition, as the first intermediate insulating film 124, the second intermediate insulating film 125, and the cover insulating film 128 are etched in the horizontal direction (X direction and/or Y direction), the third recess holes 162a, 162b, and 162c may be formed between the lower insulating gate stack structure IGSa and the intermediate insulating gate stack structure IGSb, between the intermediate insulating gate stack structure IGSb and the upper insulating gate stack structure IGSc, and between the upper insulating gate stack structure IGSc and the cover insulating film 128.

The peripheral circuit insulating layer 52, the plurality of insulating films 116, the interlayer insulating film 122, the first intermediate insulating film 124, the second intermediate insulating film 125, and the cover insulating film 128 adjacent to the preliminary contact hole 134r (see FIG. 13) in the first and second contact regions A4-1 and A4-2 are etched in a horizontal direction (X direction and/or Y direction) so that a contact hole 134 is formed.

As the plurality of insulating films 116 are etched in the horizontal direction (X direction and/or Y direction), fourth recess holes 164a, 164b, and 164c may be formed between the plurality of gate lines 126 and the plurality of first separation insulating films 156 adjacent to the lower contact gate stack structure CGSa, the intermediate contact gate stack structure CGSb, and the upper contact gate stack structure CGSc.

In addition, as the interlayer insulating film 122, the first intermediate insulating film 124, the second intermediate insulating film 125, and the cover insulating film 128 are etched in the horizontal direction (X direction and/or Y direction), fifth recess holes 166a, 166b, and 166c may be formed between the lower contact gate stack structure CGSa and the intermediate contact gate stack structure CGSb, between the intermediate contact gate stack structure CGSb and the upper contact gate stack structure CGSc, and between the upper contact gate stack structure CGSc and the cover insulating film 128.

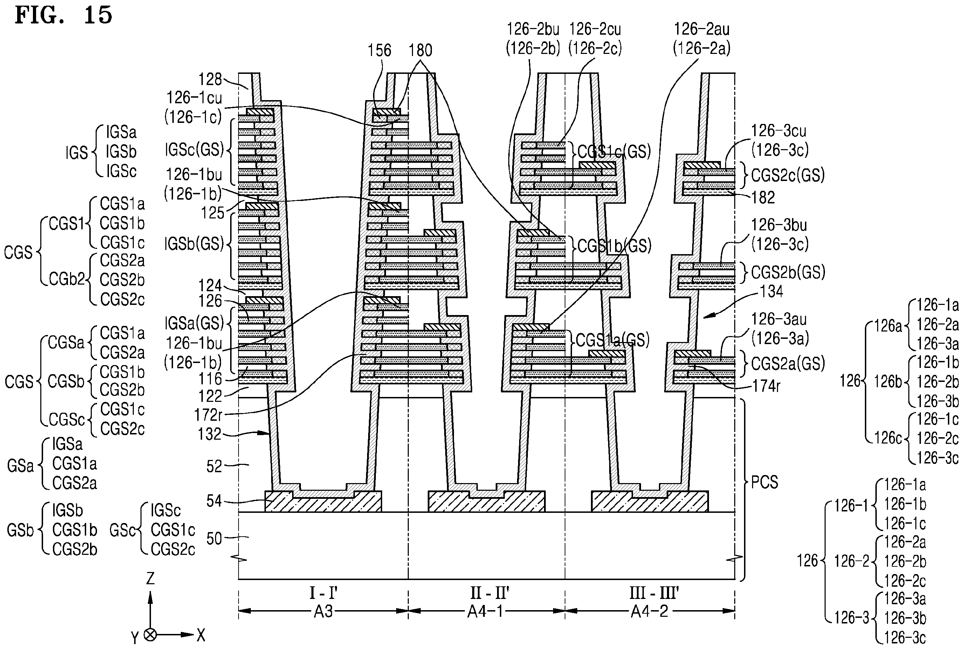

Referring to FIG. 15, a first filling insulating material layer 172r is formed on the inner wall of the through hole 132, the inside of the third recess holes 160a, 160b, and 160c, and the inside of the fourth recess holes 162a, 162b, 162c in the through electrode area A3.

A second filling insulating material film 174r is formed on the inner wall of the contact hole 134, the inside of the fourth recess holes 164a, 164b, and 164c (see FIG. 14), and the inside of the fifth recess holes 166a, 166b, and 166c (see FIG. 14) in the first and second contact regions A4-1 and A4-2.

For example, the first and second filling insulating material films 172r and 174r of each of the through electrode region A3 and the contact region A4 may be formed simultaneously. The first and second filling insulating material films 172r and 174r may include silicon oxide. For example, the first and second filling insulating material films 172r and 174r may be formed to have a thickness of several tens of nanometers.

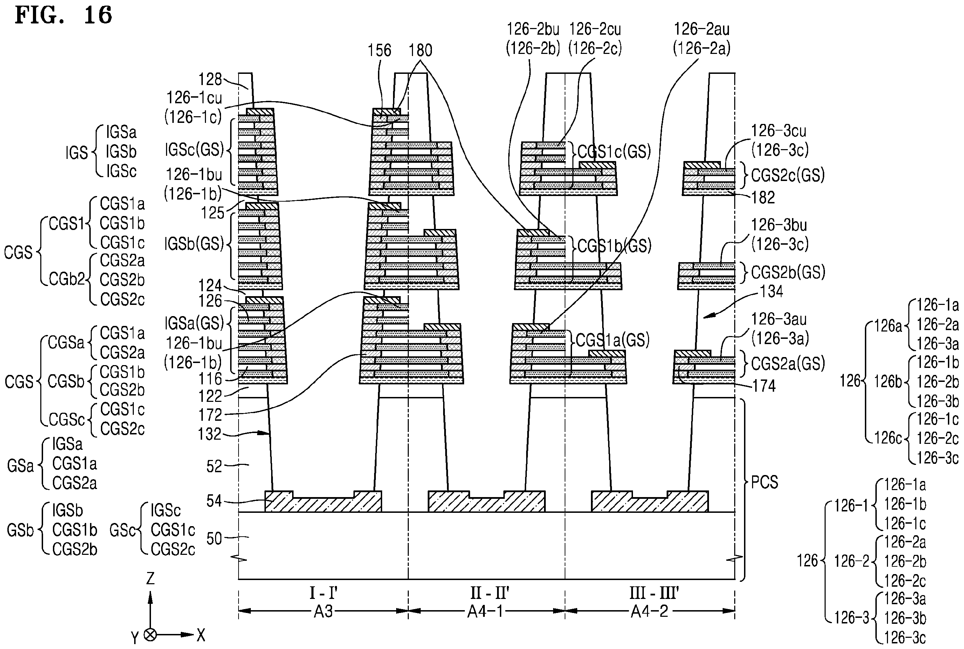

Referring to FIG. 16, the first filling insulating material film 172r (see FIG. 15) formed on the inner wall of the through hole 132 in the through electrode region A3 is etched. Accordingly, the first filling insulating film 172 is formed only inside the second recess holes 160a, 160b, and 160c (see FIG. 14).

In the first and second contact regions A4-1 and A4-2, the second filling insulating material film 174r (see FIG. 15) formed on the inner wall of the contact hole 134 is etched. Accordingly, the second filling insulating film 174 is formed only inside the fourth recess holes 164a, 164b, and 164c (see FIG. 14).

For example, the etching process of the first and second filling insulating material films 172r and 174r (see FIG. 15) of the through electrode region A3 and the contact region A4 may be simultaneously performed. Accordingly, the first and second filling insulating films 172 and 174 of the through electrode region A3 and the contact region A4 may be simultaneously formed.

Referring to FIG. 5, in the through electrode region A3, a through electrode 188 electrically connected to the peripheral circuit wiring layer 54 is formed in the through hole 132.

A first contact electrode 192 (see FIG. 5) filling the contact hole 134 may be formed in the first contact region A4-1, and a second contact electrode 194 (see FIG. 5) filling the contact hole 134 may be formed in the second contact region A4-2. The first contact electrode 192 (see FIG. 5) may directly contact the uppermost second upper gate line 126-1cu and be electrically connected to the first upper contact gate stack structure CGS1c, and the second contact electrode 194 may directly contact the uppermost third intermediate gate line 126-3bu and be electrically connected to the second intermediate contact gate stack structure CGS2b.

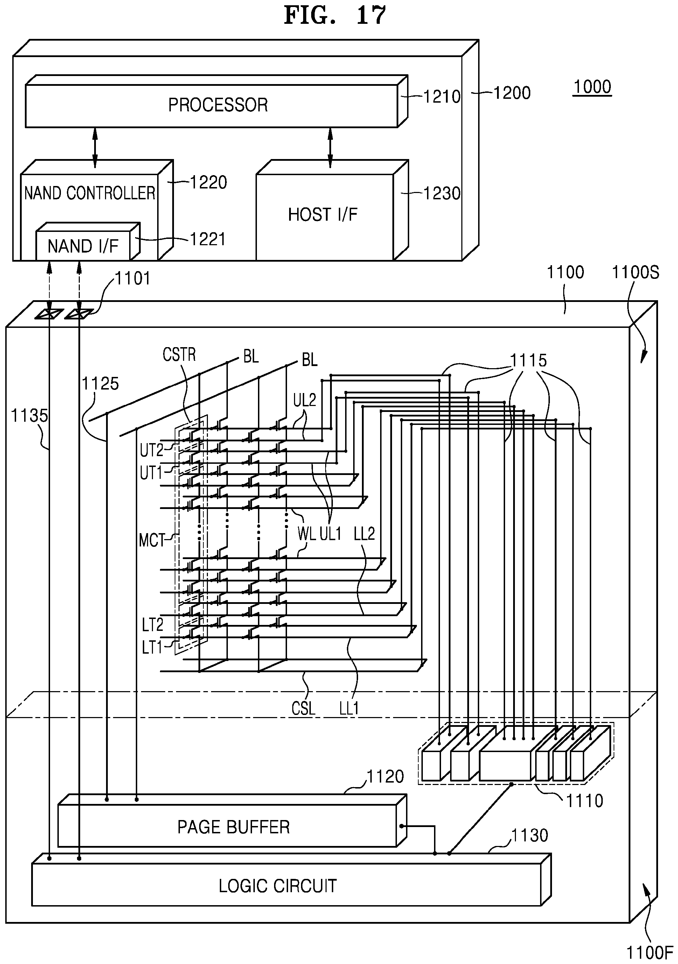

FIG. 17 is a diagram schematically illustrating an electronic system including a semiconductor memory device according to an embodiment.

Referring to FIG. 17, the electronic system 1000 may include a semiconductor device 1100 and a controller 1200 electrically connected to the semiconductor device 1100. The electronic system 1000 may be a storage device including one or a plurality of semiconductor devices 1100 or an electronic device including a storage device.

For example, the electronic system 1000 may be a solid state drive device (SSD), a universal serial bus (USB), a computing system, a medical device, or a communication device including at least one semiconductor device 1100.

The semiconductor device 1100 may be a non-volatile memory device. For example, the semiconductor device 1100 may be a NAND flash memory device that is a vertical non-volatile memory device.

The semiconductor device 1100 may include a first structure 1100F and a second structure 1 100S on the first structure 1100F. In example embodiments, the first structure 1100F may be on the side of the second structure 1 100S. The first structure 1100F may be a peripheral circuit structure including a decoder circuit 1110, a page buffer 1120, and a logic circuit 1130.

The second structure 1100S may be a memory cell structure including a bit line BL, a common source line CSL, a plurality of word lines WL, first and second gate upper lines UL1 and UL2, first and second gate lower lines LL1 and LL2, and a plurality of memory cell strings CSTR between the bit line BL and the common source line CSL.

In the second structure 1 100S, the plurality of memory cell strings CSTR may each include lower transistors LT1 and LT2 adjacent to the common source line CSL, upper transistors UT1 and UT2 adjacent to the bit line BL, and a plurality of memory cell transistors MCT between the lower transistors LT1 and LT2 and the upper transistors UT1 and UT2. The number of lower transistors LT1 and LT2 and the number of upper transistors UT1 and UT2 may vary and are not limited to the number illustrated herein.

In example embodiments, the upper transistors UT1 and UT2 may include a string select transistor, and the lower transistors LT1 and LT2 may include a ground select transistor. The plurality of gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2.

The common source line CSL, the plurality of gate lower lines LL1 and LL2, the plurality of word lines WL, and the plurality of gate upper lines UL1 and UL2 may be electrically connected to the decoder circuit 1110 through a plurality of first connection wiring 1115 extending from the first structure 1100F to the second structure 1100S. The plurality of bit lines BL may be electrically connected to the page buffer 1120 through a plurality of second connection wirings 1125 extending from the first structure 1100F to the second structure 1 100S.

In the first structure 1100F, the decoder circuit 1110 and the page buffer 1120 may perform a control operation on at least one of the plurality of memory cell transistors MCT. The decoder circuit 1110 and the page buffer 1120 may be controlled by the logic circuit 1130.

The semiconductor device 1100 may communicate with the controller 1200 through the input/output pad 1101 electrically connected to the logic circuit 1130. The input/output pad 1101 may be electrically connected to the logic circuit 1130 through an input/output connection wiring 1135 extending from the first structure 1100F to the second structure 1100S.

The controller 1200 may include a processor 1210, a NAND controller 1220, and a host interface 1230. In some embodiments, the electronic system 1000 may include a plurality of semiconductor devices 1100, and in this case, the controller 1200 may control the plurality of semiconductor devices 1100.

The processor 1210 may control the overall operation of the electronic system 1000 including the controller 1200. The processor 1210 may operate according to a preset firmware, and may access the semiconductor device 1100 by controlling the NAND controller 1220.

The NAND controller 1220 may include a NAND I/F 1221 that processes communication with the semiconductor device 1100. Through the NAND I/F 1221, a control command for controlling the semiconductor device 1100, data to be written to the plurality of memory cell transistors MCT of the semiconductor device 1100, and data to be read from the plurality of memory cell transistors MCT of the semiconductor device 1100 may be transmitted. The host interface 1230 may provide a communication function between the electronic system 1000 and an external host. When receiving a control command from an external host through the host interface 1230, the processor 1210 may control the semiconductor device 1100 in response to the control command.

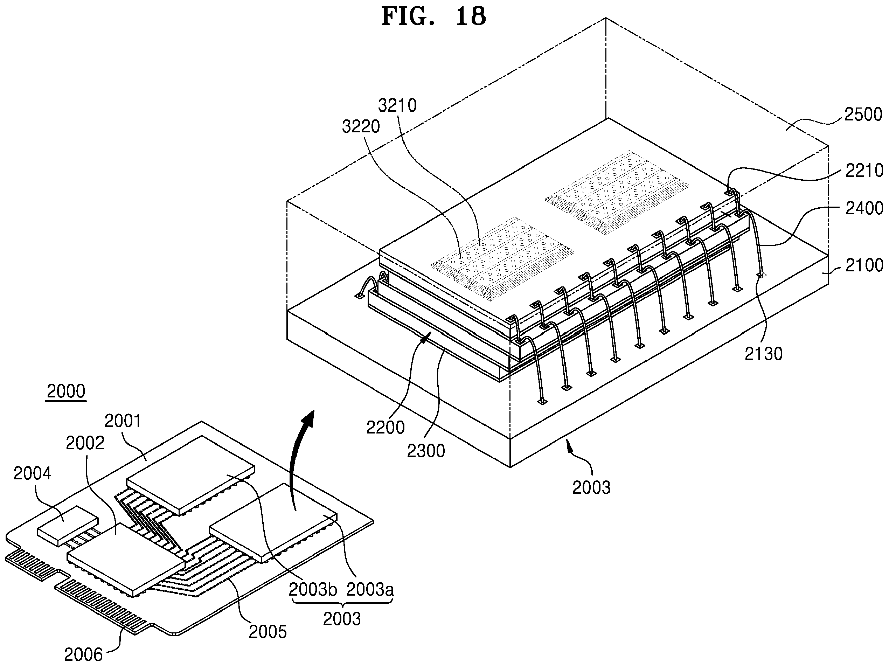

FIG. 18 is a perspective view schematically illustrating an electronic system including a semiconductor memory device according to an embodiment.

Referring to FIG. 18, an electronic system 2000 may include a main board 2001, a controller 2002 mounted on the main board 2001, one or more semiconductor packages 2003, and a dynamic random access memory (DRAM) 2004. The semiconductor package 2003 and the DRAM 2004 may be connected to the controller 2002 by a plurality of wiring patterns 2005 formed on the main board 2001.

The main board 2001 may include a connector 2006 including a plurality of pins coupled to an external host. The number and arrangement of the plurality of pins in the connector 2006 may vary according to a communication interface between the electronic system 2000 and the external host. In embodiments, the electronic system 2000 may communicate with an external host according to any one of the interfaces such as Universal Serial Bus (USB), Peripheral Component Interconnect Express (PCI-Express), Serial Advanced Technology Attachment (SATA), and M-Phy for Universal Flash Storage (UFS).

In example embodiments, the electronic system 2000 may operate by power supplied from an external host through the connector 2006. The electronic system 2000 may further include a power management integrated circuit (PMIC) for distributing power supplied from the external host to the controller 2002 and the semiconductor package 2003.

The controller 2002 may write data to or read data from the semiconductor package 2003, and may improve the operating speed of the electronic system 2000.

The DRAM 2004 may be a buffer memory for reducing a speed difference between the semiconductor package 2003, that is, a data storage space, and an external host. The DRAM 2004 included in the electronic system 2000 may operate as a cache memory, and may provide a space for temporarily storing data in a control operation for the semiconductor package 2003. When the DRAM 2004 is included in the electronic system 2000, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200.

Each of the first and second semiconductor packages 2003a and 2003b may include a package substrate 2100, a plurality of semiconductor chips 2200 on the package substrate 2100, an adhesive layer 2300 disposed on a lower surface of each of the plurality of semiconductor chips 2200, a connection structure 2400 electrically connecting the plurality of semiconductor chips 2200 to the package substrate 2100, and a molding layer 2500 covering the plurality of semiconductor chips 2200 and the connection structure 2400 on the package substrate 2100.

The package substrate 2100 may be a printed circuit board including a plurality of package upper pads 2130. Each of the plurality of semiconductor chips 2200 may include an input/output pad 2210. Each of the plurality of semiconductor chips 2200 may include a plurality of gate stacks 3210 and a plurality of channel structures 3220. Each of the plurality of semiconductor chips 2200 may include the vertical non-volatile memory device described above.

In embodiments, the connection structure 2400 may be a bonding wire electrically connecting the input/output pad 2210 and the package upper pad 2130. Accordingly, in the first and second semiconductor packages 2003a and 2003b, the plurality of semiconductor chips 2200 may be electrically connected to each other by a bonding wire method, and may be electrically connected to the package upper pad 2130 of the package substrate 2100.

According to embodiments, in relation to the first and second semiconductor packages 2003a and 2003b, the plurality of semiconductor chips 2200 may be electrically connected to each other by a connection structure including a through silicon via (TSV) instead of the bonding wire type connection structure 2400.

In example embodiments, the controller 2002 and the plurality of semiconductor chips 2200 may be included in one package. In embodiments, the controller 2002 and the plurality of semiconductor chips 2200 may be mounted on a separate interposer substrate different from the main board 2001, and the controller 2002 and the plurality of semiconductor chips 2200 may be connected to each other by wirings formed on the interposer substrate.

While the present disclosure has been particularly shown and described with reference to embodiments thereof, it will be understood that various changes in form and details may be made therein without departing from the scope of the following claims.

Certain embodiments of the invention may be defined by the following numbered clauses. For convenience, we have numbered these clauses from 8 to 13.
8. A semiconductor memory device comprising:
   a memory cell region comprising a plurality of memory cells on a substrate that comprises a main surface that is parallel to a horizontal direction; and
   a connection region that is adjacent to the memory cell region and that contacts the memory cell region,
   wherein the connection region comprises:
      a plurality of gate stack structures comprising a plurality of gate lines and a plurality of insulating films, wherein the plurality of gate lines are stacked in a vertical direction that is perpendicular to the horizontal direction, wherein the plurality of insulating films are between the plurality of gate lines;
      a plurality of first separation insulating films that are adjacent to each of the plurality of gate lines, wherein the plurality of gate stack structures and the plurality of first separation insulating films define a contact hole that extends in the vertical direction, wherein each of the plurality of gate lines extends in the horizontal direction and through the contact hole;
      a contact electrode that is in the contact hole and contacts the plurality of gate stack structures;
      one or more second separation insulating films on an uppermost gate line of each of one or more gate stack structure among the plurality of gate stack structures, wherein the one or more second separation insulating film separates the contact electrode from the uppermost gate line; and
      one or more intermediate insulating films between each of the plurality of gate stack structures.
9. The semiconductor memory device of clause 8, wherein a first side of each of the plurality of first separation insulating films contacts the plurality of gate lines, and a second side of each of the plurality of first separation insulating films contacts the contact electrode.
10. The semiconductor memory device of clause 8 or 9, wherein at least a portion of an upper surface of the one or more second separation insulating films contacts the contact electrode, and
   wherein at least a portion of a lower surface of each of the one or more second separation insulating films contacts the uppermost gate line.
11. The semiconductor memory device of clause 8, 9 or 10, wherein an entire upper surface of the plurality of first separation insulating films that contacts the uppermost gate line of each given gate structure contacts the one or more second separation insulating films.
12. The semiconductor memory device of clause 8, 9 10 or 11, further comprising a plurality of filling insulating films in the contact hole and between adjacent gate lines from among the plurality of gate lines, wherein the plurality of filling insulating films are between a plurality of adjacent first separation insulating films from among the plurality of first separation insulating films, wherein the plurality of filling insulating films extend in the horizontal direction,
   wherein each of the plurality of filling insulating films is in the contact hole, and
   wherein at least a portion of each of the one or more second separation insulating films is external to the contact hole.
13. The semiconductor memory device of clause 12, wherein an upper surface and a lower surface of each of the plurality of filling insulating films contact the plurality of gate lines and the plurality of first separation insulating films, and
   wherein a side surface of each of the plurality of filling insulating films contacts the contact electrode and the contact hole.

## Claims

1. A semiconductor memory device comprising:
a substrate comprising a main surface that is parallel to a horizontal direction;
a plurality of gate stack structures on the substrate and comprising a plurality of gate lines and a plurality of insulating films, wherein the plurality of gate lines are stacked in a vertical direction that is perpendicular to the horizontal direction, and wherein the plurality of insulating films are between the plurality of gate lines;
a plurality of first separation insulating films that are alternately stacked with the plurality of gate lines, wherein the plurality of gate stack structures and the plurality of first separation insulating films define a contact hole that extends in the vertical direction, wherein each of the plurality of gate lines extends in the horizontal direction and through the contact hole;
a contact electrode that is in the contact hole and contacts the plurality of gate stack structures; and
one or more second separation insulating films on an uppermost gate line of one or more of the plurality of gate stack structures, wherein the one or more second separation insulating films separate the contact electrode from the uppermost gate line.

2. The semiconductor memory device of claim 1, wherein a first side of each of the plurality of first separation insulating films contacts the plurality of gate lines, and a second side of each of the plurality of first separation insulating films contacts the contact electrode.

3. The semiconductor memory device of claim 1 or 2, wherein at least a portion of a lower surface of the one or more second separation insulating films contacts the uppermost gate line, and
wherein at least a portion of the one or more second separation insulating films is external to the contact hole.

4. The semiconductor memory device of any preceding claim, wherein an inner wall of the one or more second separation insulating films contacts the contact electrode, and
wherein an outer wall of the one or more second separation insulating films is spaced apart from the contact electrode in the horizontal direction.

5. The semiconductor memory device of any preceding claim, further comprising a plurality of lower separation insulating films on a lower surface of a lowermost gate line, wherein the plurality of lower separation insulating films extend in the horizontal direction, and wherein the plurality of lower separation insulating films separate the contact electrode from the lowermost gate line.

6. The semiconductor memory device of claim 5, wherein an upper surface of each of the plurality of lower separation insulating films contacts the lowermost gate line.

7. The semiconductor memory device of claim 5, wherein at least one of the upper surfaces of the plurality of lower separation insulating films contacts the lowermost gate line.

8. A semiconductor memory device comprising:
a memory cell region comprising a plurality of memory cells on a substrate that comprises a main surface that is parallel to a horizontal direction; and
a connection region that is adjacent to the memory cell region and that contacts the memory cell region,
wherein the connection region comprises a semiconductor memory device as claimed in any preceding claim;
and wherein said semiconductor memory device further comprises one or more intermediate insulating films between each of the plurality of gate stack structures.

9. The semiconductor memory device of any preceding claim, wherein at least a portion of an upper surface of the one or more second separation insulating films contacts the contact electrode, and
wherein at least a portion of a lower surface of each of the one or more second separation insulating films contacts the uppermost gate line.

10. The semiconductor memory device of any preceding claim, wherein an entire upper surface of the plurality of first separation insulating films that contacts the uppermost gate line of each given gate structure contacts the one or more second separation insulating films.

11. The semiconductor memory device of any preceding claim, further comprising a plurality of filling insulating films in the contact hole and between adjacent gate lines from among the plurality of gate lines, wherein the plurality of filling insulating films are between a plurality of adjacent first separation insulating films from among the plurality of first separation insulating films, wherein the plurality of filling insulating films extend in the horizontal direction,
wherein each of the plurality of filling insulating films is in the contact hole, and
wherein at least a portion of each of the one or more second separation insulating films is external to the contact hole.

12. The semiconductor memory device of claim 11, wherein an upper surface and a lower surface of each of the plurality of filling insulating films contact the plurality of gate lines and the plurality of first separation insulating films, and
wherein a side surface of each of the plurality of filling insulating films contacts the contact electrode and the contact hole.

13. A semiconductor memory device comprising:
a memory cell region comprising a plurality of memory cells on a substrate that comprises main surface that is parallel to a horizontal direction;
a through electrode region, TER, that is on a first side of the memory cell region and contacts a peripheral circuit wiring layer on the substrate; and
a contact region, CR, that is on one side of the through electrode and contacts the memory cell region,
wherein the through electrode region comprises:
one or more insulating gate stack structures that comprise an interlayer insulating film, a plurality of TER gate lines stacked in a vertical direction perpendicular to the horizontal direction and on the interlayer insulating film, and a plurality of TER insulating films between the plurality of gate lines;
a through hole that extends in the vertical direction and from the peripheral circuit wiring layer of the substrate, wherein the through hole exposes the peripheral circuit wiring layer; and
a through electrode that extends in the horizontal direction and in the through hole, wherein the through electrode is on a plurality of first TER separation insulating films that are on one side of each of the TER gate lines and the through hole, and
wherein the contact region comprises:
a plurality of gate stack structures including a plurality of CR gate lines and a plurality of CR insulating films alternately stacked in the vertical direction;
a contact hole that extends in the vertical direction and in each of the plurality of gate stack structures, wherein the plurality of gate stack structures extend in the horizontal direction and in the contact hole, and the plurality of first CR separation insulating films are on one side of each first gate line;
a contact electrode that is in the contact hole and contacts the plurality of gate stack structures;
one or more second CR separation insulating films on an uppermost gate line of each of one or more gate stack structure among the plurality of gate stack structures, wherein the one or more second CR separation insulation films separate the contact electrode from the uppermost gate line; and
one or more intermediate CR insulating films between each of the plurality of gate stack structures.

14. The semiconductor memory device of claim 13, further comprising one or more second TER separation insulating films on the uppermost gate line of each of the one or more insulating gate stack structures.
